# DEMANDE DE BREVET EUROPEEN

(11) **EP 4 131 421 A1**
(43) Date de publication de la demande: **08.02.2023**
(21) Numéro de dépôt: 22187723.6
(22) Date de dépôt: 29.07.2022
(51) Int. Cl.: H01L 29/66, H01L 29/423, H01L 27/10, H01L 29/82, B82Y 10/00, H01L 29/06

(54) **DISPOSITIF POUR LE STOCKAGE, LE CONTRÔLE ET LA MANIPULATION DE L' INFORMATION QUANTIQUE (QUBITS) SUR SEMI-CONDUCTEUR**

(30) Priorité: 04.08.2021 FR 2108459
(71) Demandeur: Commissariat à l'Energie Atomique et aux Energies Alternatives, 75015 Paris (FR)
(72) Inventeur: JACQUINOT, Hélène, 38054 Grenoble Cedex 09 (FR)
(74) Mandataire: Cabinet Camus Lebkiri

(57) **Abrégé**

Dispositif (11) électronique pour le stockage, le contrôle et la manipulation de qubits sur semi-conducteur, à base de spins d'électron ou de trou, le dispositif comprenant une couche isolante (20) électriquement et :
- sur une face avant (21) de la couche isolante, une structure de piégeage (1) pour électrons ou trous qui comporte : une portion de canal (2) comprenant au moins une portion de couche en matériau semi-conducteur, ainsi qu'une pluralité de grilles (3) réparties pour piéger au moins un électron ou un trou dans la portion de canal, les grilles de la structure de piégeage étant réparties le long de lignes parallèles entre elles, et
- du côté arrière (24) de la couche isolante, une piste (30) électrique qui s'étend parallèlement à la couche isolante, destinée à générer un champ magnétique oscillant (B_{AC}) s'exerçant sur ledit au moins un électron ou trou piégé dans la structure de piégeage, la piste comportant plusieurs portions, chacune parallèle auxdites lignes, et les pistes parallèles étant connectées électriquement en série les unes à la suite des autres pour former des méandres.

## Description

### DOMAINE TECHNIQUE

Le domaine technique est celui des ordinateurs quantiques, et, plus généralement, celui du stockage, du contrôle et de la manipulation de qubits. La présente technologie concerne plus précisément un dispositif pour le stockage, le contrôle et la manipulation de l'information quantique (qubits) sur semi-conducteurs, le support physique de chaque qubit étant le spin d'un électron ou d'un trou stocké dans le dispositif.

### ARRIÈRE-PLAN TECHNOLOGIQUE

Le domaine de l'information quantique et du calcul quantique a connu un fort développement ces dernières années. Différentes technologies sont en cours de développement pour réaliser des ordinateurs quantiques dans lesquels on stocke, on contrôle et on manipule des qubits, pouvant d'ailleurs être couplés les uns aux autres, au lieu de stocker des données binaires classiques de type 0 ou 1. De tels qubits peuvent en particulier correspondre au spin d'un électron ou d'un trou, électron ou trou qui est piégé dans une boite quantique, structure à base de semi-conducteur refroidie par cryogénie issue des techniques de la microélectronique.

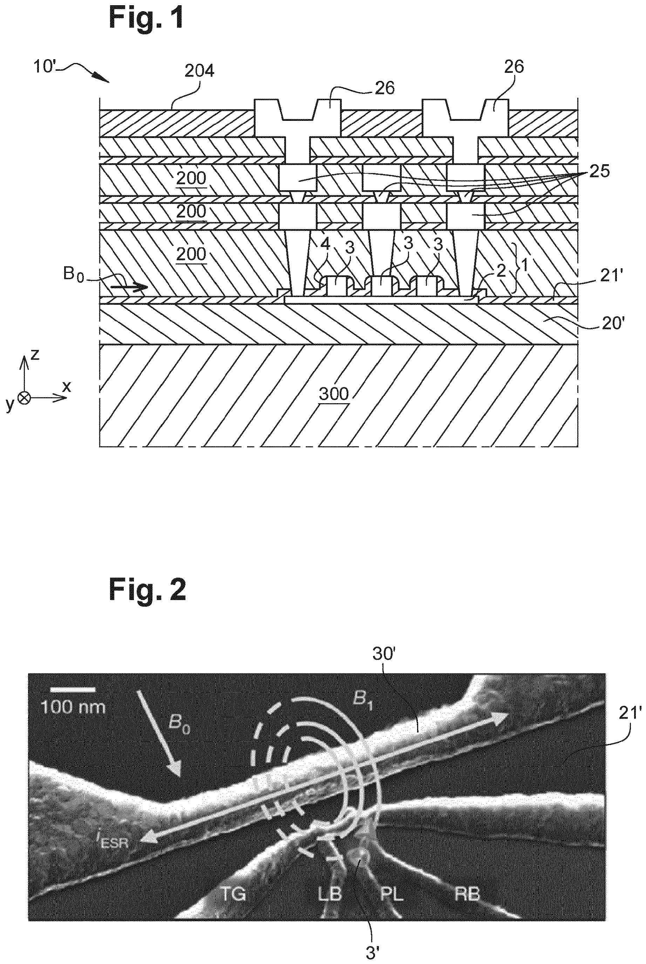

La figure 1 représente schématiquement un dispositif 10' comprenant une telle structure de piégeage 1, vu en coupe et de côté. Ce dispositif est réalisé à partir d'un substrat de type silicium sur isolant « SOI », comportant initialement une mince couche de silicium qui recouvre une couche d'oxyde de silicium enterrée (appelée habituellement « BOX »), l'ensemble étant supporté par une couche de silicium 'standard' (de résistivité égale à 10 Ohm.cm par exemple) ou bien HR-Si (silicium de haute résistivité électrique de 10 kOhm.cm par exemple), plus épaisse, qui porte la référence 300 sur la figure 1. La couche d'oxyde de silicium forme une couche isolante 20' sur laquelle est réalisée la structure de piégeage 1.

Cette structure comprend une portion de canal 2, en silicium (par exemple en silicium ²⁸Si isotopiquement pur), et des grilles (appelées « gate » en microélectronique) réparties sur cette portion de canal 2 sur un niveau (comme c'est le cas pour les grilles 3 représentées sur la figure 1) ou sur plusieurs niveaux (grilles supplémentaires, sur des niveaux supérieurs, non représentées ici). Chaque grille comprend typiquement un empilement de grille, avec au moins une couche isolante pour séparer le reste de la grille de la portion de canal 2. L'ensemble est recouvert par exemple par une couche en nitrure de silicium 4 (isolante électriquement). En contrôlant électriquement l'ensemble des grilles du dispositif (dont les grilles 3), en particulier en termes de potentiel électrique DC, on peut créer des boites quantiques réparties dans la portion de canal (c'est-à-dire des pièges, de petite dimension, réparties dans cette portion). En général, le dispositif comporte un ensemble de grilles qui contrôlent le puits de potentiel des boites quantiques et un ensemble de grilles qui contrôle les barrières tunnel entre boites quantiques. Les boites quantiques ainsi créés peuvent être utilisées pour stocker l'information quantique (qubits), pour la lecture des qubits ou encore pour avoir des réservoirs de charges.

Un champ magnétique constant B₀ est généralement appliqué à la structure de piégeage, et entraîne une précession du spin de l'électron en question (dans le cas de la figure 1, le champ magnétique B₀ est orienté selon une direction x parallèle au substrat). L'application de ce champ magnétique statique (par exemple compris entre 100 mT et 1 T) permet de bien distinguer (bien séparer) les deux niveaux, « spin down » et « spin up », associés au spin des quasi-particules piégées, et d'obtenir ainsi un système quantique à deux niveaux bien contrôlable. Pour manipuler le spin de l'électron piégé et modifier son orientation dans la sphère de Bloch, on peut alors appliquer un champ magnétique oscillant à cet électron (champ magnétique B_{AC}, ayant par exemple une fréquence dans le domaine des gigahertz, ce champ magnétique oscillant ayant au moins une composante perpendiculaire au champ magnétique « orientateur » constant Bo. Cela permet notamment de faire basculer le spin de son état + à son état -. Cette technique, appelée « ESR » (selon l'acronyme anglo-saxon de « Electron Spin Resonance ») est couramment utilisée pour de tels qubits sur semi-conducteurs, à base de spin d'électron. Pour des électrons, ce contrôle du spin par résonance est généralement réalisée grâce à un champ magnétique oscillant, comme indiqué au-dessus. Dans le cas de trous, comme l'interaction spin-orbite est importante, on peut employer, on peut aussi employer une technique appelée EDSR (Electrical Dipole Spin Resonance) dans laquelle on utilise un champ électrique alternatif aux mêmes fréquences. Dans le cas de l'ESR, il est nécessaire de générer un champ électromagnétique où seule la partie magnétique du champ électromagnétique sera utile. La partie électrique du champ électromagnétique est quant à elle source de parasite et on cherche donc à la minimiser.

Le dispositif 10' comprend une couche d'encapsulation 200, typiquement en oxyde de silicium, qui protège la structure de piégeage. Il comprend aussi d'autres couches d'encapsulation 200, et un ensemble de conducteurs électriques d'interconnexion 25 qui relient électriquement l'ensemble des grilles (dont les grilles 3) (et aussi la portion de canal 2) à des plots de contact 26 distants. Cet ensemble fait partie de la structure, appelée habituellement BEOL (pour « Back End Of Line » en anglais), qui permet d'interfacer les qubits en question. L'ensemble des conducteurs électriques d'interconnexion 25 comprend notamment des vias conducteurs et des pistes électriques qui s'étendent parallèlement au substrat, et permettent de déporter la connexion électrique des grilles 3.

Pour générer le champ magnétique oscillant B_{AC} mentionné plus haut, on peut utiliser une piste électrique, par exemple en forme de spire, réalisée sur la face supérieure 204 de l'empilement de « Back End Of Line » (cette piste n'est pas représentée, sur la figue 1), cette piste électrique étant parcourue par un courant électrique alternatif I_{ESR} de même fréquence que le champ magnétique à générer.

Mais le champ magnétique oscillant en question est alors appliqué sur l'ensemble du dispositif, et notamment sur le réseau d'interconnexion 25, risquant ainsi d'induire des signaux parasites indésirables.

De plus, l'éloignement assez important entre les qubits, et la piste servant à générer le champ magnétique oscillant, impose d'employer un courant électrique alternatif assez intense, ce qui peut être une source d'échauffements indésirables, dans l'environnement cryogénique où est plongé le dispositif 10'.

Une autre solution pour créer ce champ magnétique variable est de réaliser le ou les qubits 3', ainsi qu'une piste électrique 30' sur la face 21' d'une couche isolante, la piste passant juste à côté du ou des qubits, par exemple à quelques dizaines de nanomètres de celui-ci, comme représenté sur la figure 2 (figure qui est la figure 1.a. de l'article de Pla, J. et al., « A single-atom electron spin qubit in silicon », Nature 489, 541-545, 2012).

Cette proximité permet d'obtenir un champ magnétique oscillant intense, pour une intensité modérée du courant I_{ESR}.

Mais cette configuration pose des problèmes d'encombrement : une partie de la zone située autour des boites quantiques destinées à piéger les électrons ou trous est occupé par cette piste 30' et par les pistes annexes d'amenée du courant électrique I_{ESR}. Or l'environnement de ces boites quantiques est déjà en lui-même, très encombré, notamment du fait de la présence des conducteurs électriques employés pour piloter le ou les qubits.

### RESUME

Dans ce contexte, on propose un dispositif électronique pour le stockage, le contrôle et la manipulation de qubits sur semi-conducteur, à base de spins d'électron ou de trou, le dispositif comprenant :
- une couche isolante électriquement avec, du côté avant, une face avant, et du côté arrière, une face arrière,
- sur la face avant de la couche isolante, une structure de piégeage pour électrons ou trous qui comporte :
   - une portion de canal, formée au moins en partie par une portion de couche en matériau semi-conducteur s'étendant dans un plan parallèle à ladite couche isolante, et
   - une pluralité de grilles distinctes les unes des autres, réparties en un ou plusieurs niveaux sur la portion de canal, d'un côté de la portion de canal opposé à ladite couche isolante (pour piéger au moins un électron ou un trou dans la portion de canal), les grilles de la structure de piégeage étant réparties le long de lignes parallèles entre elles,
- du côté arrière de la couche isolante, une piste électrique qui s'étend dans un plan parallèle à la couche isolante, destinée à générer un champ magnétique oscillant s'exerçant sur ledit au moins un électron ou trou piégé dans la structure de piégeage, la piste comportant plusieurs portions, chacune parallèle auxdites lignes, et qui sont connectées électriquement en série les unes à la suite des autres pour former des méandres.

Comme expliqué plus loin, cette configuration de piste (avec ces portions connectées en série en formant des méandres) est favorable pour obtenir un champ magnétique ayant une composante perpendiculaire aux couches, au niveau des électrons ou trous piégés ; elle permet par ailleurs de localiser ce champ magnétique au voisinage des pistes (avec une décroissance rapide de l'amplitude du magnétique en fonction de la distance).

La présente technologie concerne aussi un dispositif, tel que décrit ci-dessus,
- mais comportant plusieurs pistes électriques, dont ladite piste, ces pistes étant situées dans un même plan et étant chacune parallèle auxdites lignes de grilles, lesdites pistes *étant connectées électriquement en parallèles les unes par rapport aux autres,*
- au lieu de comprendre desdites portions de pistes connectées électriquement en série les unes à la suite des autres pour former des méandres.

Cette dernière configuration, avec une alimentation électrique en parallèle (et donc un courant électrique dans le même sens) pour ces différentes pistes est favorable quant à elle à l'obtention d'un champ magnétique ayant une composante parallèle aux couches, au niveau des électrons ou trous piégés.

Par ailleurs, comme la piste électrique est située d'un côté de la couche isolante opposé à la structure de piégeage, cette piste électrique peut jouer également le rôle d'une « grille de face arrière », appelée couramment 'back-gate' en anglais, en plus de créer le champ magnétique en question, permettant ainsi de disposer d'un moyen supplémentaire pour contrôler le paysage de potentiel électrique au sein de la portion de canal où est piégé ledit au moins un électron ou trou.

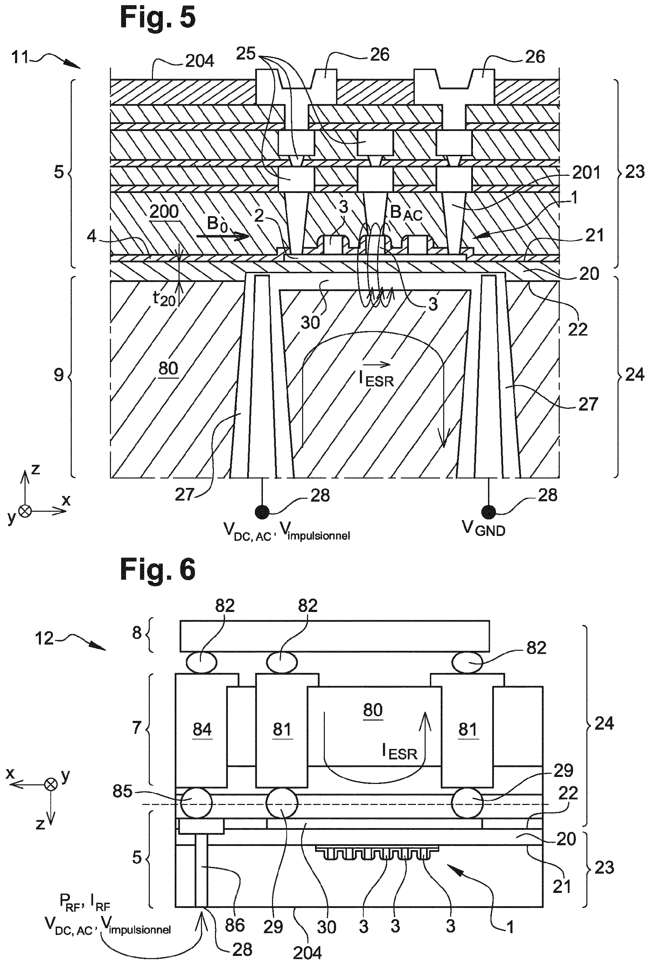

La piste électrique, destinée à générer le champ magnétique oscillant pour la résonance ESR (appelée piste « ESR » dans la suite), est donc réalisée en face arrière (du côté du « back-side », d'un point de vue technologique), tandis que la structure de piégeage est réalisée en face avant (du côté du « front-side »). Les vias et lignes conductrices pour l'interconnexion électrique des grilles de la structure de piégeage sont d'ailleurs généralement réalisés eux aussi du côté avant de la couche isolante en question (voir la figure 5 par exemple).

Comme indiqué juste au-dessus, cette piste électrique, de par la possibilité d'ajuster une polarisation de la structure de piégeage (ou éventuellement des structures de piégeages), arrière (du côté opposé à la structure de piégeage par rapport à la couche isolante) permet un contrôle additionnel du paysage de potentiel électrique au sein de la portion de canal (notamment pour contrôler les boites quantiques mentionné plus haut). Plus précisément, une telle 'back-gate' permet de contrôler indépendamment la profondeur du puits de potentiel ainsi que le champ électrique au sein de la boite quantique, ce qui présente un avantage certain (en l'absence de « back-gate » on ne peut pas contrôler le champ électrique dans la boite quantique indépendamment de sa profondeur, ce champ électrique étant alors lié directement à la profondeur du puits, en étant d'autant plus fort que le puits est profond).

Le dispositif est typiquement réalisé à partir d'un substrat de type semi-conducteur sur isolant, par exemple un substrat de type Silicium sur isolant « SOI » ou de type Germanium sur isolant « GeOI ». Un tel substrat comprend initialement une mince couche de semi-conducteur (par exemple une mince couche de silicium) recouvrant une couche d'oxyde de ce semi-conducteur, enterrée (le « box »), l'ensemble étant supporté par une couche dudit semi-conducteur, plus épaisse, et ayant généralement une résistivité électrique élevée (pas ou peu de dopage intentionnel, pour cette couche support). C'est alors cette couche d'oxyde de semi-conducteur enterrée (éventuellement amincie au cours de la fabrication), qui, après fabrication, forme la couche isolante mentionnée plus haut, sur laquelle est située la structure de piégeage, et sous laquelle s'étend la piste électrique « ESR ».

Par rapport à une réalisation uniquement en face avant, l'ajout de structures en face arrière de la couche isolante (l'ajout de la piste électrique « ESR », et des conducteurs électriques pour l'interconnexion de cette piste) complique la fabrication. Cette fabrication des deux côtés peut notamment nécessiter un retournement du substrat en cours de la fabrication et l'ajout de structures servant de poignées ou de renforts structurels.

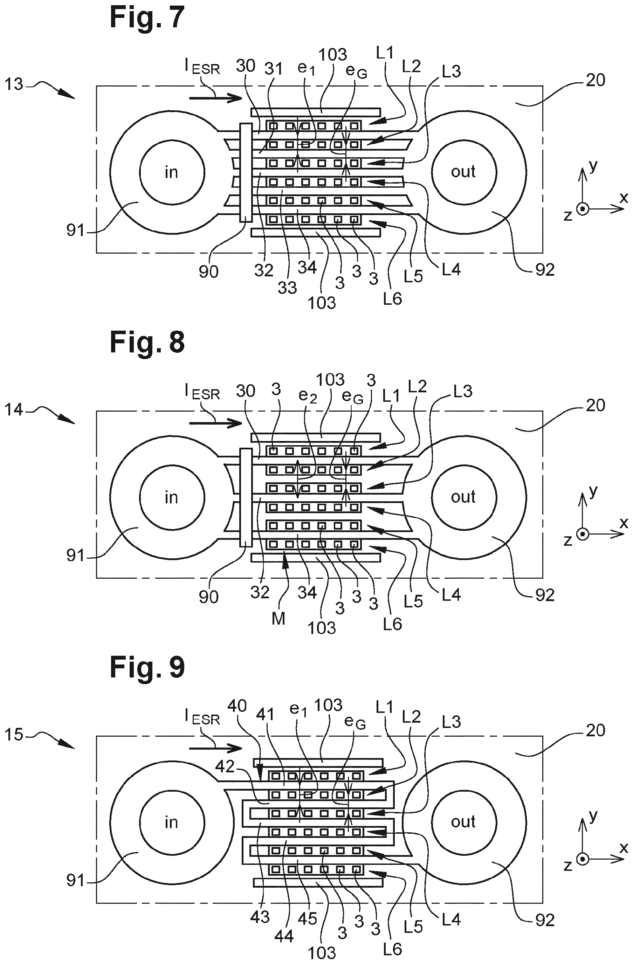

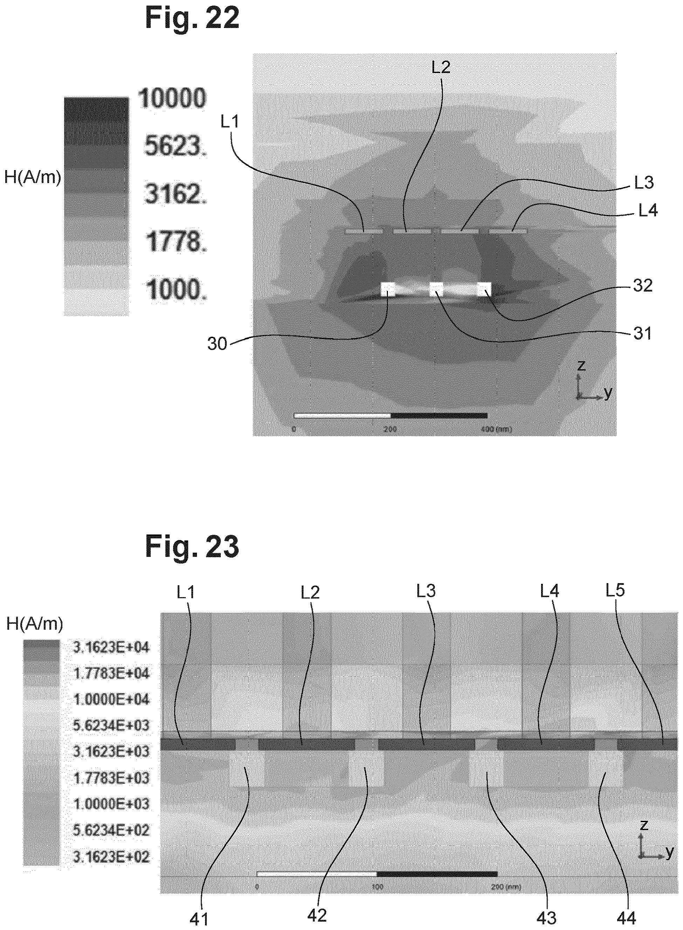

Mais en contrepartie, la réalisation de la piste « ESR » en face arrière présente de nombreux intérêts :
- en face avant, cela permet de libérer la zone située au voisinage immédiat de la structure de piégeage, et élimine ainsi les problèmes d'encombrement de cette zone mentionnés plus haut (en référence à la figure 2); cette simplification est particulièrement intéressante lorsque la structure de piégeage forme une matrice de pièges bidimensionnelle, laissant peu d'accès aux qubits d'un point de vue latéral ;
- le champ électromagnétique oscillant, exercé sur la partie avant du dispositif autre que la structure de piégeage, en particulier celui exercé sur la structure d'interconnexion des grilles (vias et lignes conductrices), est limité (et les signaux parasites pouvant être induits par ce champ sont donc avantageusement limités eux aussi), puisque la source de ce champ électromagnétique, qui est la piste ESR en question, est distante de la partie avant du dispositif (cette piste étant située en partie arrière) ; de ce point de vue, la configuration revendiquée est nettement plus intéressante que la configuration de l'art antérieur mentionnée plus haut en référence à la figure 1, dans laquelle la piste « ESR » est réalisée sur une face (face supérieure 204) du « back end of line » (voir la figure 1) ; cet avantage peut d'ailleurs être renforcé en donnant à la piste « ESR » une forme de serpentin (avec des méandres), avec des portions successives parcourues en sens opposé par le courant électrique de manière à créer un champ magnétique fort à proximité de la piste, mais décroissant très rapidement lorsqu'on s'éloigne de la piste (voir les figures 9 et 23 par exemple) ;
- En outre, cette configuration permet d'appliquer un potentiel électrique statique (DC) ou tout signal électrique (BF, RF, impulsionnel...) contrôlé en face arrière des qubits (à l'opposé des grilles, par rapport à la portion de canal mentionnée plus haut), ce qui apporte un degré de liberté supplémentaire pour contrôler le paysage d'énergie (à puits de potentiel) dans lequel sont piégés les électrons ou trous, et cela sans avoir à ajouter de structure supplémentaire pour le contrôle de ce potentiel ;
- réaliser la piste « ESR » du côté arrière de la couche isolante permet une souplesse de configuration très importante pour cette piste, si bien que la géométrie de la piste peut être choisie avec beaucoup de liberté (en « serpentin » ou non ; décalé latéralement par rapport aux qubits ou non ; avec une périodicité latérale égale à celle de la matrice 2D de qubits, ou égale au double de celle-ci, etc...) ; Pouvoir choisir librement cette géométrie est intéressant car elle influence directement les propriétés du champs magnétique créé (principalement perpendiculaire à la couche, ou au contraire parallèle à celle-ci ; ayant une décroissance forte en fonction de la distance, ou non, etc...) ;
- réaliser la piste « ESR » du côté arrière de la couche isolante permet en outre d'employer des types de technologies micro-électroniques différentes (en particulier des types de matériaux différents) pour la partie située du côté avant (structure de piégeage) et pour la partie située du côté arrière (piste ESR). On peut ainsi utiliser des matériaux supraconducteurs pour la piste ESR qui présentent l'avantage de réduire considérablement la partie électrique du champ électromagnétique générée par la piste ESR et ainsi les parasites induits par le champ électrique.

La portion de canal de la structure de piégeage est située sur la couche isolante en question, soit directement sur la couche isolante (autrement dit, contre la couche isolante, au contact de celle-ci), soit en étant séparée de la couche isolante par une ou des couches annexes, généralement de faible épaisseur (par exemple moins de 0,2 micron ou même moins de 50nm). De même, la piste « ESR » peut être réalisée directement sous la couche isolante en question, contre celle-ci, ou être séparée de la couche isolante par une ou plusieurs autres couches, telle qu'une couche de métallisation par exemple.

On notera que, lorsque la couche isolante en question constitue initialement, avant fabrication, tout ou partie de la couche d'oxyde enterrée d'un substrat de type semi-conducteur sur isolant, elle présente des propriétés particulières, par rapport à une couche d'oxyde quelconque. En termes de qualité d'interface (faible densité de pièges ou défauts à l'interface) et de régularité par exemple, cette couche d'oxyde thermique présente des propriétés meilleures qu'une couche d'oxyde de semi-conducteur quelconque telle qu'une couche d'encapsulation réalisée par oxydation plasma ou dépôts à basse température (typiquement à moins de 500 ou 600 degrés Celsius) par exemple. La spécificité de cette couche est également sa faible épaisseur, typiquement inférieure à 150 nm, par exemple 15 nm, qui lui confère également une grande régularité. Cette régularité se manifeste notamment en surface, où elle permet un meilleur accord avec une couche du semi-conducteur en question (par exemple du silicium) qui serait épitaxiée sur la couche isolante, par exemple pour réaliser la portion de canal, ou, tout simplement avec la couche supérieure initiale du substrat de type semi-conducteur sur isolant, gravée pour former la portion de canal en question.

Plus généralement, la couche isolante peut être formée d'un oxyde du semi-conducteur en question (par exemple de l'oxyde de silicium SiO₂) ayant subi un recuit à très haute température (supérieure à 700 et même à 1000 degrés Celsius) liée à la technologie 'smart-cut'. Par rapport à une couche d'oxyde réalisée à froid, telle que la couche de diélectrique entre le FEOL, 'Front-end-of-line', partie inférieure où sont réalisés le canal et les grilles et le BEOL (partie supérieure de la structure d'interconnexion des grilles), une telle couche d'oxyde thermique présente de meilleures propriétés en termes de rugosité résiduelle en surface, de propension à l'ouverture ou la propagation de fissures, et plus généralement de qualité d'interface.

Outre les caractéristiques présentées ci-dessus, le dispositif présenté ci-dessus peut présenter une ou plusieurs des caractéristiques optionnelles suivantes, considérées individuellement ou selon toutes les combinaisons techniquement envisageables :
- la couche isolante a une épaisseur comprise entre 5 nm et 200 nm, voire comprise entre 10 nm (10 nanomètres) et 150 nm ;
- ladite piste et lesdites grilles sont séparées par une distance inférieure ou égale à 200 nanomètres, selon une direction perpendiculaire à la couche isolante ;
- ladite piste et lesdites grilles sont séparées par une distance inférieure ou égale à 100 nm, selon une direction perpendiculaire à la couche isolante ; on notera qu'une telle distance est nettement inférieure à l'épaisseur usuelle d'une couche d'encapsulation (généralement supérieure à 200 nm, ou plus), et que, en général, dans un dispositif de micro-électronique intégré, la distance entre le premier plan de métallisation, et les zones actives situées sous les grilles, est habituellement supérieure à 200 nm au moins ;
- en projection sur un plan parallèle à la couche isolante, chaque grille est séparée de ladite piste par un écart latéral qui est inférieur ou égal à ladite distance ;
- en projection sur un plan parallèle à la couche isolante, chaque grille est séparée de ladite piste par un écart latéral qui est inférieur ou égal à 200 nm, voire inférieur ou égal à 100 nm ;
- ladite piste est séparée de ladite face arrière par une couche intermédiaire ; ou, au contraire, ladite piste est située directement contre ladite face arrière ;
- la couche isolante est formée au moins en partie d'un oxyde de semi-conducteur ayant subi un recuit à une température supérieure à 700 degrés Celsius ;
- la couche isolante est une couche en oxyde de semi-conducteur constituant une partie au moins de la couche d'oxyde enterré d'un substrat de type semi-conducteur sur isolant, tel qu'un substrat de type Silicium sur isolant « SOI » ou de type Germanium sur isolant « GeOI » ; la couche épaisse support du substrat, qui supporte initialement la couche d'oxyde enterrée, peut être entièrement retirée au cours de la fabrication et n'être plus présente dans le dispositif, une fois fabriqué. La couche d'oxyde enterrée peut en outre être amincie, soit sur toute sa surface soit plus localement, au niveau de la piste ESR. En variante, la couche support du substrat pourrait être conservée en partie, en étant gravée au niveau de la piste ESR (pour donner accès à la face arrière de la couche d'oxyde enterrée), mais pas sur toute la surface du substrat ;
- le dispositif comprend en outre un premier ensemble de conducteurs électriques d'interconnexion, qui relient électriquement les grilles à des premiers plots ou éléments de contacts distants de la structure de piégeage, ce premier ensemble de conducteurs s'étendant du coté avant de la couche isolante ;
- le dispositif comprend en outre un deuxième ensemble de conducteurs électriques d'interconnexion, qui relient électriquement ladite piste à des deuxièmes plots ou éléments de contacts distants de ladite piste, ce deuxième ensemble de conducteurs s'étendant du côté arrière de la couche isolante ;
- le dispositif ne comprend pas de connecteur électrique qui soit relié électriquement aux grilles et qui soit situé du côté arrière de la couche isolante ;
- le dispositif ne comprend pas de connecteur électrique qui soit relié électriquement à ladite piste et qui soit situé du côté avant de la couche isolante ;
- en projection sur un plan parallèle à la couche isolante, la piste se superpose au moins en partie avec chacune des grilles, voire même, se superpose avec la totalité de chaque grille ; autrement formulé, il y a un recouvrement vertical, au moins partiel, entre la piste et chacune des grilles ; dit encore autrement, pour chaque grille, une partie au moins de la piste est située à l'aplomb d'une partie de la grille ;
- lesdites pistes, ou lesdites portions de piste, sont espacées latéralement l'une de l'autre de manière périodique, avec un espacement qui est le même que l'espacement qui sépare, latéralement, deux lignes de grilles adjacentes ;
- lesdites pistes, ou lesdites portions de piste, sont espacées latéralement l'une de l'autre de manière périodique, avec un espacement qui est le double de l'espacement qui sépare, latéralement, deux lignes de grilles adjacentes ;
- en projection sur un plan parallèle à la couche isolante, chaque piste, ou chacune desdites portions de piste, est intercalée entre deux lignes de grilles adjacentes ;
- en projection sur un plan parallèle à la couche isolante, ladite piste forme plusieurs portions de boucle, chaque portion de boucle étant située au niveau de l'une desdites grilles ou au niveau d'un îlot de grilles regroupant une partie desdites grilles ;
- en projection sur un plan parallèle à la couche isolante, chaque portion de boucle entoure en partie la grille ou l'îlot de grilles correspondant.

La présente technologie concerne aussi un procédé de pilotage d'un dispositif électronique tel que présenté ci-dessus, dans lequel un courant électrique alternatif est injecté dans la ladite piste électrique pour exercer un champ magnétique oscillant sur ledit au moins un électron ou trou piégé dans ladite structure de piégeage, et dans lequel la piste électrique est employée en outre en tant que grille arrière, un potentiel électrique étant appliqué à ladite piste électrique pour contrôler un paysage de potentiel électrique au sein de la portion de canal où est piégé ledit au moins un électron ou trou. Le potentiel électrique en question est par exemple un potentiel électrique statique, ou basse fréquence (fréquence inférieure à 10kHz), ou radiofréquence (fréquence comprise entre 10kHz et 100 GHz), ou impulsionnel, ou étant une combinaison de tels potentiels électriques. Il peut s'agir d'encore un autre type de signal électrique.

La présente technologie concerne aussi un procédé de fabrication d'un dispositif électronique pour le stockage, le contrôle et la manipulation de qubits sur semi-conducteur, à base de spins d'électron ou de trou, le dispositif comprenant une couche isolante électriquement avec, du côté avant, une face avant, et du côté arrière, une face arrière, le procédé comprenant les étapes suivantes :
- sur la face avant de la couche isolante, réalisation d'une structure de piégeage pour électrons ou trous qui comporte :
   - une portion de canal, formée au moins en partie par une portion de couche en matériau semi-conducteur s'étendant dans un plan parallèle à ladite couche isolante, et
   - une pluralité de grilles distinctes les unes des autres, réparties en un ou plusieurs niveaux sur la portion de canal, d'un côté de la portion de canal opposé à ladite couche isolante, les grilles de la structure de piégeage étant réparties le long de lignes parallèles entre elles, et
- du côté arrière de la couche isolante, réalisation d'une piste électrique qui s'étend dans un plan parallèle à la couche isolante, destinée à générer un champ magnétique oscillant s'exerçant sur ledit au moins un électron ou trou piégé dans la structure de piégeage, la piste comportant plusieurs portions, chacune parallèle auxdites lignes, et qui sont connectées électriquement en série les unes à la suite des autres pour former des méandres.

La présente technologie concerne aussi un procédé de fabrication, tel que décrit ci-dessus, mais dans lequel plus pistes, dont ladite piste, sont fabriquées, au lieu desdites portions de lignes formant un méandre, ces pistes étant situées dans un même plan et étant chacune parallèle auxdites lignes de grilles, lesdites pistes étant connectées électriquement en parallèles les unes par rapport aux autres.

Les caractéristiques optionnelles présentées ci-dessus en termes de fabrication peuvent aussi s'appliquer à ce procédé de fabrication.

La présente technologie et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif.
[Fig. 1] La figure 1 représente schématiquement un dispositif pour le stockage, le contrôle et la manipulation de qubits sur semi-conducteur de l'état de la technique, vu de côté, en coupe.
[Fig. 2] La figure 2 est une vue, en microscopie électronique à balayage, d'un autre dispositif pour le stockage, le contrôle et la manipulation de qubits sur semi-conducteur de l'état de la technique.
[Fig. 3] La figure 3 représente schématiquement, vu de dessous, un premier mode de réalisation d'un dispositif pour le stockage, le contrôle et la manipulation de qubits sur semi-conducteur mettant en œuvre la présente technologie.
[Fig. 4] La figure 4 représente schématiquement le dispositif de la figure 3, vu en coupe et de côté.
[Fig. 5] La figure 5 représente schématiquement un deuxième mode de réalisation d'un tel dispositif, vu en coupe et de côté.
[Fig. 6] La figure 6 représente schématiquement un troisième mode de réalisation d'un tel dispositif, vu en coupe et de côté.
[Fig. 7] La figure 7 représente schématiquement un quatrième mode de réalisation d'un tel dispositif, vu de dessous.
[Fig. 8] La figure 8 représente schématiquement un cinquième mode de réalisation d'un tel dispositif, vu de dessous.
[Fig. 9] La figure 9 représente schématiquement un sixième mode de réalisation d'un tel dispositif, vu de dessous.
[Fig. 10] La figure 10 représente schématiquement un septième mode de réalisation d'un tel dispositif, vu de dessous.
[Fig. 11] La figure 11 représente schématiquement un huitième mode de réalisation d'un tel dispositif, vu de dessous.
[Fig. 12] La figure 12 représente schématiquement, vu de dessous, un dispositif pour le stockage, le contrôle et la manipulation de qubits sur semi-conducteur comprenant deux dispositifs tels que celui de la figure 7, mis en réseau l'un à la suite de l'autre.
[Fig. 13] La figure 13 représente schématiquement, vu de dessous, un dispositif pour le stockage, le contrôle et la manipulation de qubits sur semi-conducteur comprenant plusieurs dispositifs tels que celui de la figure 7, mis en réseau.
[Fig. 14] La figure 14 représente schématiquement une variante envisageable pour la géométrie d'une piste électrique pour résonance ESR pouvant équiper l'un quelconque des dispositifs des figures 3 à 13.
[Fig. 15] La figure 15 représente schématiquement une autre variante d'une telle piste ESR.
[Fig. 16] La figure 16 représente schématiquement encore une autre variante d'une telle piste ESR.
[Fig. 17] La figure 17 représente schématiquement encore une autre variante d'une telle piste ESR.
[Fig. 18] La figure 18 représente schématiquement encore une autre variante d'une telle piste ESR.
[Fig. 19] La figure 19 représente schématiquement encore une autre variante d'une telle piste ESR.
[Fig. 20] La figure 20 représente schématiquement encore une autre variante d'une telle piste ESR.
[Fig. 21] La figure 21 représente schématiquement encore une autre variante d'une telle piste ESR.
[Fig. 22] La figure 22 représente schématiquement, en coupe axiale, des résultats de simulation numérique de l'excitation magnétique générée par des pistes pour résonance ESR, en différents points d'un dispositif pour le stockage, le contrôle et la manipulation de qubits sur semi-conducteur.
[Fig. 23] La figure 23 représente schématiquement, en coupe axiale, des résultats de simulation numérique de l'excitation magnétique générée par des pistes pour résonance ESR, en différents points d'un autre dispositif pour le stockage, le contrôle et la manipulation de qubits sur semi-conducteur.
[Fig. 24] La figure 24 représente schématiquement une variante du dispositif de la figure 4, vu en coupe et de côté.

### DESCRIPTION DÉTAILLÉE

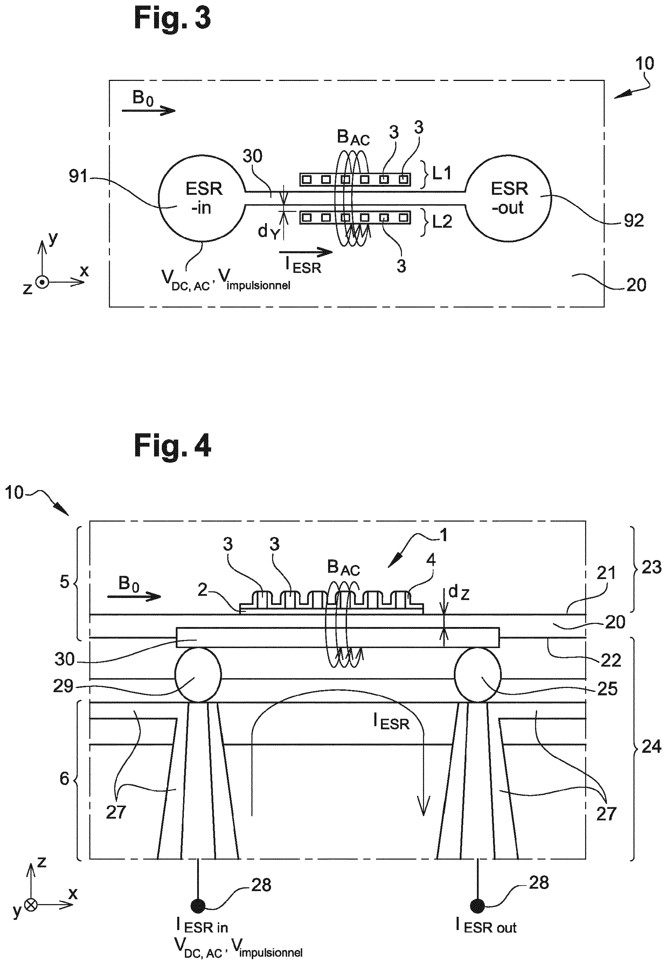

La présente technologie concerne un dispositif électronique pour le stockage, le contrôle et la manipulation de qubits sur semi-conducteur, à base de spin d'électron ou de trou. Ce dispositif comprend (voir les figures 4 et 5 par exemple) :
- une structure de piégeage 1 pour piéger le ou les électrons (ou trous), dont le ou les spins peuvent être employés comme qubits, et
- une piste électrique (piste 30, sur les figures 4 et 5), qui, lorsqu'elle est parcourue par un courant électrique I_{ESR}, alternatif, génère un champ magnétique oscillant B_{AC} qui s'exerce sur le ou les électrons piégés dans la structure de piégeage 1, ce qui permet de manipuler leur(s) spin(s) par résonance de type ESR ; cette piste électrique est appelée indifféremment piste ESR, ou simplement piste ou piste électrique, dans la suite.

De manière remarquable, la structure de piégeage 1 est réalisée sur une face avant 21 d'une couche isolante 20, du côté avant 23 de cette couche, tandis que la piste ESR est située du côté arrière 24 de la couche isolante.

La piste ESR est ainsi réalisée en face arrière (du côté du « back-side », d'un point de vue technologique), alors que la structure de piégeage 1, ainsi d'ailleurs que sa connectique 25, sont réalisées en face avant (du côté du « front-side »). Initialement, avant la fabrication du dispositif, la couche isolante 20 en question forme le « box », c'est-à-dire par exemple la couche d'oxyde de silicium enterrée d'un substrat de type silicium sur isolant « SOI ».

Comme expliqué dans la partie intitulée « résumé », cette configuration, avec la piste ESR réalisée en face arrière, permet :
- de réduire l'encombrement dans l'environnement immédiat des qubits,
- de réduire le champ magnétique oscillant dans la partie supérieure du dispositif, en particulier dans la connectique 25 (diminution des signaux parasites induits),
- d'appliquer un potentiel électrique contrôlé en face arrière de la structure de piégeage, pour contrôler le paysage d'énergie dans lequel sont piégés les électrons ou trous,
- de disposer d'une grande liberté concernant la configuration géométrique de la piste ESR.

La piste ESR en question peut d'ailleurs comporter plusieurs portions contiguës. Et, en face arrière, le dispositif peut comporter plusieurs pistes ESR, dont celle mentionnée ci-dessus, parcourues par un courant électrique alternatif, et qui contribuent ensemble à la génération du champ magnétique oscillant B_{AC}.

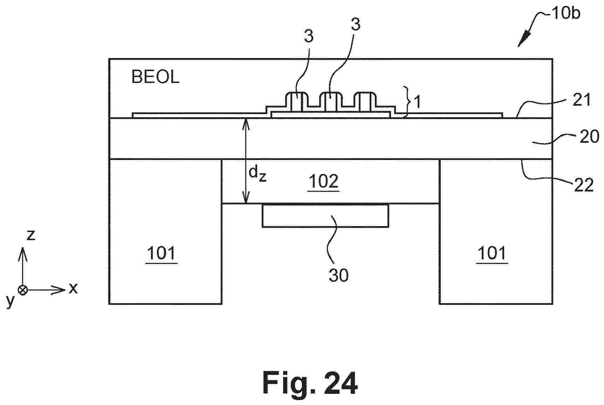

Plusieurs modes de réalisation du dispositif, qui portent respectivement les références 10, 11, 12, 13, 14, 15, 16, 17, 18 et 19 sont représentés respectivement sur les figures 3, 5, 6, 7, 8, 9, 10, 11, 12 et 13. La figure 24 présente par ailleurs une variante, 10b, du dispositif 10 de la figure 4.

Les modes de réalisation 13 à 19 diffèrent principalement l'un de l'autre de par le nombre, la forme ou l'agencement de la piste ESR, ou des pistes ESR, dans le plan dans lequel s'étendent la ou les pistes ESR (plan parallèle à la couche isolante 20).

Ces différents modes de réalisation présentent néanmoins de nombreux points communs. Aussi, d'un mode de réalisation à l'autre, les éléments identiques ou correspondants seront généralement repérés par les mêmes signes de référence.

Dans un premier temps, on décrira de manière générale la structure d'ensemble du dispositif 10 ; 10b ; 11 ; 12 ; 13 ; 14 ; 15 ; 16 ; 17 ; 18 ; 19, et différents éléments que peuvent comprendre respectivement, la partie avant 24, et la partie arrière 23 du dispositif (structure de piégeage, éléments d'interconnexion ou d'assemblage, piste ESR). Différentes formes et agencement envisageables pour la ou les pistes ESR en elles-mêmes seront présentées ensuite, en référence aux figures 7 à 21. Les modes de réalisation du dispositif 10, 10b et 11 sont présentés pour illustrer certains aspects du dispositif (notamment des aspects communs aux différents modes de réalisation), mais ils ne correspondent pas, en propre, à l'invention revendiquée, telle que définie par la revendication 1 déposée initialement (car ils comportent une seule piste ESR, rectiligne). Par ailleurs, les modes de réalisation 12 à 14, et 17 à 19 correspondent à une alternative du dispositif, différente du dispositif défini par la revendication 1 déposée initialement.

### Structure d'ensemble

La couche isolante 20 est délimitée, du côté avant, par une face avant 21, et du côté arrière, par une face arrière 22, toutes deux parallèles à la couche isolante 20 (voir sur les figures 4 à 6). Cette couche sépare le côté avant du dispositif, 23, de son côté arrière 24. La couche isolante 20 a ici une épaisseur t₂₀ faible, inférieure à 200 nm ou même à 100 ou 10 nm. Comme indiqué plus haut, cette couche isolante, formait, avant la fabrication du dispositif, tout ou partie d'une couche d'oxyde enterrée d'un substrat de type silicium sur isolant SOI. Il s'agit d'une couche d'oxyde de silicium ayant subi un recuit, à une température au moins supérieure à 700 ou même 1000 degrés Celsius.

Quel que soit le mode de réalisation considéré, la structure de piégeage 1 comprend :
- une portion de canal 2 comprenant au moins une portion de couche en matériau semi-conducteur parallèle à la couche isolante 20, et
- une pluralité de grilles 3 distinctes les unes des autres, réparties en un ou plusieurs niveaux sur la portion de canal 2, d'un côté de la portion de canal opposé à la couche isolante 20 (donc du côté avant de la portion de canal).

En contrôlant électriquement les grilles 3, en particulier en termes de potentiel électrique DC, on peut créer un puits ou des puits de potentiel dans la portion de canal 2, et y piéger un ou plusieurs électrons ou trous, dont le spin peut servir de qubit. Des contacts électriques sont réalisés en plus sur la portion de canal 2 (voir par exemple le via conducteur 201, sur la figure 5), pour remplir des fonctions de drain et de source. On notera que plusieurs grilles peuvent être employées ensemble pour créer l'un de ces puits de potentiel (l'une des boites quantiques). Autrement dit, on peut avoir plusieurs grilles (par exemple deux) associées à un seul piège. Par ailleurs, tous les électrons ou trous piégés ne servent pas nécessairement, chacun, à stocker un qubit. Et l'on pourrait envisager d'employer ensemble plusieurs électrons piégés pour stocker une seule variable quantique (sous forme collective, dans cet ensemble spins). Par ailleurs, telles que représentées sur les figures 4 à 6, les grilles 3 sont réparties sur un même niveau, sur la portion de canal 2 (c'est-à-dire dans un même plan, parallèle à la portion de canal, ou, autrement formulé, à une même hauteur vis-à-vis de la portion de canal). En variante, le dispositif pourrait toutefois comprendre des grilles supplémentaires, réparties sur un autre niveau par rapport à la portion de canal (par exemple plus loin de celle-ci). Quoiqu'il en soit, le fait que les grilles soient réparties sur la portion de canal ne signifie pas nécessairement qu'elles sont situées directement contre cette portion de canal (une ou des couches intermédiaires peuvent être présentes). En général, l'ensemble des grilles (notamment les grilles 3 représentées sur les figures) sont reliées électriquement à des plots ou éléments de contact distants (via le BEOL), comme expliqué plus bas.

La portion de canal 2 s'étend sur la face avant 21 de la couche isolante 20, par exemple directement sur cette face, en contact avec celle-ci. En variante, une ou des couches annexes pourraient toutefois être intercalées entre la portion de canal 2 et la face avant 21. La portion de canal 2 est par exemple formée entièrement de silicium (par exemple du silicium ²⁸Si isotopiquement pur) ou d'un alliage de silicium et de germanium, ou d'un empilement de sous-couches, certaines en silicium et d'autres formée d'un alliage de silicium et de germanium. La portion de canal a une épaisseur comprise typiquement entre 5 et 200 nm, ou même entre 10 et 30 nm. Il s'agit d'une portion de canal en ce sens que les électrons ou trous pourraient de déplacer au sein de cet élément 2, si l'on fait abstraction des pièges créés en polarisant les grilles. Et il s'agit d'une *portion* de canal car cet élément est délimité latéralement, et n'occupe une petite partie de la face 21.

Chaque grille 3 comprend typiquement un empilement de grille, avec au moins une couche isolante (par exemple en oxyde de silicium thermique, c'est-à-dire ayant été recuit à au moins 700 ou même 1000 degrés) séparant la portion de canal 2 d'un empilement de métaux (TiN, Ta ou Al par exemple) et/ou de silicium polycristallin de la grille.

Sur la portion de canal 2, les grilles 3 peuvent être réparties le long d'une même ligne, l'une à la suite de l'autre. Elles peuvent aussi être réparties le long de différentes lignes L1, L2, L3, ..., L6 parallèles entre elles (voir les figures 3 et 7 par exemple), avec, le long de chacune de ces lignes, des grilles réparties l'une à la suite de l'autre (cas des modes de réalisation représentés sur les figures).

Chacune de ces lignes L1, L2, L3, ..., L6 est alors parallèle à un même axe, noté x, axe qui est parallèle à la couche isolante 20. L'axe y représenté sur les figures est un axe parallèle à la couche isolante 20 et perpendiculaire à l'axe x. Quant à l'axe z, il est perpendiculaire à la couche isolante 20. Ce système de trois axes x,y,z est utilisé de manière identique sur l'ensemble des figures 3 à 23.

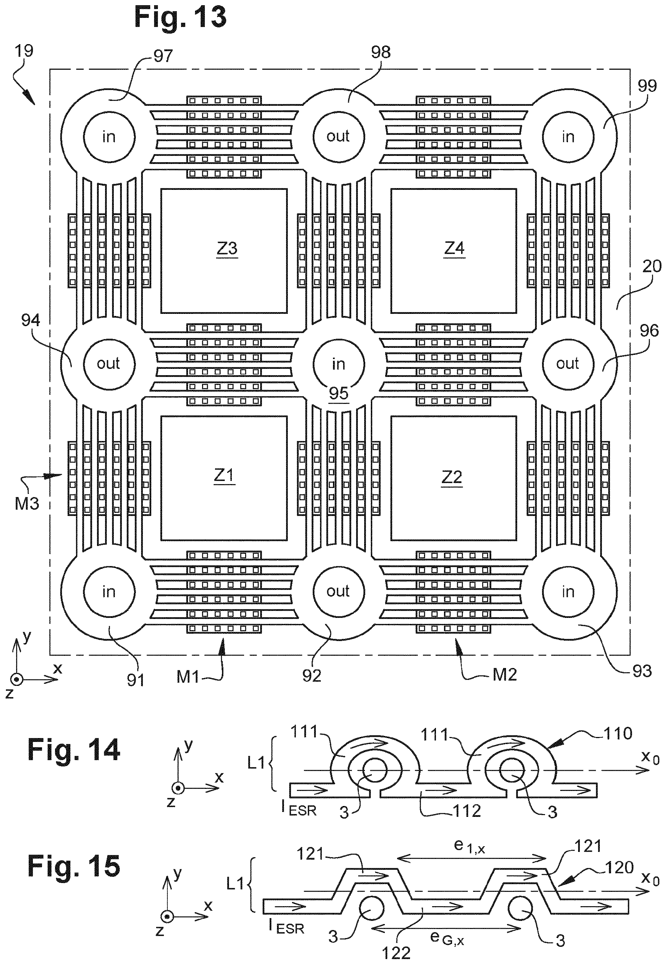

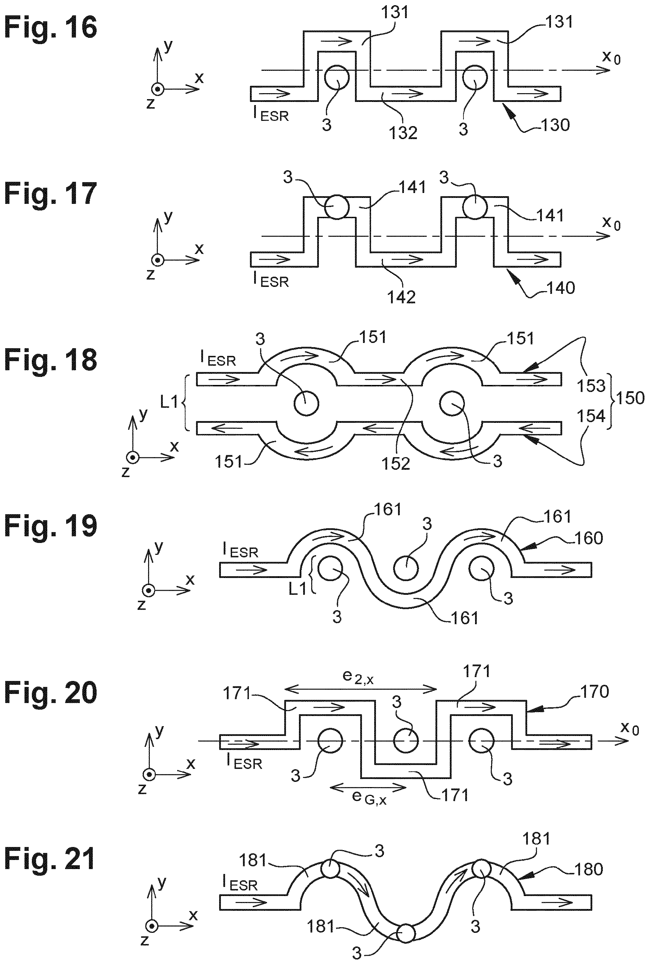

Ici, les grilles 3 sont plus précisément réparties en matrice, c'est-à-dire à la fois en lignes et en colonnes. Autrement dit, elles sont réparties périodiquement en formant un réseau rectangulaire. Parallèlement à l'axe x, les grilles 3 sont répétées avec un pas e_{G,X} (figures 15 et 20). Parallèlement à l'axe y, elles sont répétées avec un pas e_{G} (figures 7 à 10), qui est l'écart latéral entre deux lignes L1 - L6 de grilles 3 adjacentes. Le pas e_{G,X} et le pas e_{G} (pas de photo-répétition) sont par exemple compris chacun entre 50 nm et 1 micron, ou même entre 50 et 200 nm.

Dans d'autres modes de réalisation (non représentés), les grilles pourraient être regroupées en ilots, par exemple en ilots de deux ou quatre grilles, les ilots pouvant alors être eux-mêmes répartis en ligne l'un à la suite de l'autre, ou en matrice, sur la portion de canal 2. Chaque îlot de grilles peut servir à stocker, contrôler et manipuler soit un unique qubit (correspond au cas où plusieurs grilles sont employées pour contrôler chaque piège), soit éventuellement plusieurs qubits.

L'ensemble comprenant la portion de canal 2 et les grilles 3 est recouvert d'une couche en matériau diélectrique 4, de préférence un matériau diélectrique pouvant servir de couche d'arrêt lors de la gravure des contacts électriques des grilles ou du drain/source. Ce matériau est par exemple du nitrure de silicium. Une couche d'encapsulation 200 isolante, typiquement en oxyde de silicium, recouvre la structure de piégeage 1 et le reste de la couche isolante 20. Cette couche est traversée de vias conducteurs, tels que le via 201 mentionné plus haut.

Le dispositif 10 ; 10b ; 11 ; 12 ; 13 ; 14 ; 15 ; 16 ; 17 ; 18 ; 19 comprend aussi un premier ensemble de conducteurs électriques d'interconnexion, 25, qui relient électriquement les grilles 3, ainsi que la ou les sources et drains, à des premiers plots 26 ou éléments de contacts distants de la structure de piégeage 1. Ce premier ensemble de conducteurs 25 s'étendant du coté avant 23, mais non du côté arrière de la couche isolante 20 (voir la figure 5 ; sur les figures 4 et 6, cet ensemble de conducteurs n'a pas été représenté pour ne pas alourdir la figure). Les plots 26 ou les éléments de contacts sont situés du côté avant du dispositif, par exemple sur une face avant 204 du dispositif.

Ce premier ensemble de conducteurs 25 est situé dans une partie avant du dispositif, appelée habituellement BEOL (pour « Back End Of Line » en anglais), dans laquelle est réalisée une structure d'interconnexion électrique tridimensionnelle qui comprend typiquement des couches isolantes (par exemple d'autres couches d'encapsulation 200) pouvant être traversées par vias conducteurs, ainsi que des plans de métallisation parallèles aux couches, gravés pour obtenir des pistes d'interconnexion conductrices, dont certaines font partie du premier ensemble de conducteurs 25 mentionnés ci-dessus (ensemble 25 employé pour déporter la connexion électrique des grilles 3). L'ensemble de cette structure a généralement une épaisseur supérieure à 1 micron, voire supérieure à 10 microns

Un champ magnétique constant B₀ est appliqué à la structure de piégeage 1, pour faire précesser le spin de chaque électron piégé, stocké dans la structure de piégeage 1. Dans l'exemple de la figure 5, ce champ est parallèle à l'axe x. Il pourrait toutefois être orienté différemment.

La piste électrique ESR, qui porte la référence 30 sur les figures 3 à 6, génère le champ magnétique oscillant B_{AC} mentionné plus haut, lorsqu'elle est parcourue par le courant alternatif I_{ESR}. Comme déjà indiqué, cette piste est située du côté arrière 24 de la couche isolante 20. Elle s'étend parallèlement à la couche isolante 20. Elle a par exemple une largeur comprise entre 30 nm à 2 microns, et même plutôt comprise entre 30 nm et 200 nm. Elle est formée d'un matériau ayant une forte conductivité électrique à température cryogénique tel qu'un matériau supraconducteur comme le nitrure de Titane ou de Nobium, le Nobium ou encore l'Aluminium. De préférence, ce matériau supraconducteur est un supraconducteur de type 1.

Ici, la piste ESR est proche des grilles 3 (et donc en pratique proche des électrons ou trous piégés), avec, pour chaque grille, une distance typiquement inférieure à 300 nm ou même inférieure à 200 voire à 150 nm entre la piste et la grille considéré. Lorsque le dispositif comprend plusieurs pistes ESR (figure 7), la distance en question est la distance entre la grille considérée et la piste ESR qui est la plus proche de celle-ci. Et lorsque la piste ESR du dispositif comprend plusieurs portions affectées respectivement aux différentes lignes de grilles, chaque portion étant parallèle aux lignes de grilles (figure 9), la distance en question est la distance entre la grille considérée et la portion de la piste qui est la plus proche de cette grille.

Cette proximité permet de générer, au niveau des électrons piégés, un champ magnétique oscillant ayant une amplitude typique comprise entre 1 et 30 milliteslas pour une intensité du courant I_{ESR} restant modérée, comprise typiquement entre 0,1 et 10 milliampères. Cette proximité permet aussi, pour une amplitude du champ B_{AC} donnée au niveau des grilles, de limiter l'amplitude du champ magnétique oscillant qui s'exerce ailleurs dans le dispositif, en particulier dans la partie BEOL mentionnée plus haut.

Cette proximité entre la piste ESR et les grilles 3 (plus précisément : entre la piste ESR et le ou les puits de potentiels situés dans la portion de canal) résulte notamment du caractère peu épais (au moins localement) de la couche isolante 20. Cette couche forme initialement le box d'un substrat de type SOI (substrat ayant servi de base pour la fabrication du dispositif), ou tout au moins une partie de ce box, lorsque celui-ci a été aminci au cours du procédé de fabrication. Quoiqu'il en soit, le fait que des substrats SOI avec des box initialement peu épais soient disponibles commercialement (200 nm, voire moins) facilite l'obtention d'une telle couche isolante 20 peu épaisse.

La piste ESR peut être située directement contre la face arrière 22 de la couche isolante 20 (couche 20 qui peut être gravée ou amincie localement, au niveau de la piste ESR). La piste ESR peut aussi être séparée de cette face arrière 22 par une ou des couches annexes. Cette couche annexe est par exemple une couche de métallisation. Il peut aussi s'agir, comme dans le cas du dispositif 10b de la figure 24, d'une couche supplémentaire 102, relativement mince, en silicium (en quelque sorte résiduelle) correspondant à une partie de la couche support 101 HR-Si du substrat SOI qui n'aurait pas été retirée (cas d'une couche HR-Si pas complètement amincie, ou pas complètement gravée). Cette couche supplémentaire pourrait aussi être une couche formée d'un matériau (en pratique, un matériau diélectrique) autre que du silicium. Par ailleurs, la couche de métallisation mentionnée plus haut pourrait être intercalée entre la piste ESR et cette couche supplémentaire 102. Quoiqu'il en soit, que ces couches annexes soient présentes ou non, la distance dz qui, selon l'axe z, sépare la ou les pistes ESR des grilles 3 est ici inférieure à 200 nm, et même inférieure à 150 nm ou même à 100 nm (voire inférieure à 20 nm, avec par exemple un box et une portion de canal de 10nm d'épaisseur chacun). Cette distance correspond à la distance, selon l'axe z, entre la piste ESR et la face arrière de chaque grille 3 (face de la grille qui est en contact avec la portion de canal 2).

Dans les modes de réalisation représentés sur les figures, la ou les pistes ESR sont également proches des grilles 3 d'un point de vue latéral. Lorsque le dispositif comprend une seule piste ESR, cette piste passe soit directement sous les grilles 3, à l'aplomb de chaque grille (voir la figure 17 par exemple), soit en étant décalée latéralement, mais avec un écart latéral d_{y} par rapport aux grilles faible. L'écart latéral d_{y} est la distance qui, en projection sur un plan parallèle à la couche isolante 20, sépare la piste ESR du bord de la grille 3 considérée (voir la figure 3). Et lorsque le dispositif comprend plusieurs pistes ESR, l'écart latéral d_{y} est la distance qui, en projection sur un plan parallèle à la couche isolante 20, sépare le bord de la grille 3 considérée de la piste ESR qui est la plus proche.

L'écart latéral d_{y} en question est par exemple inférieur ou égal à la distance dz mentionnée ci-dessus. Il peut être inférieur ou égal à 200 nm, ou même à 150 ou 100 nm (voire à 60 ou même 20 nm).

A titre d'exemple, pour le dispositif 10 correspondant au mode de réalisation de la figure 3 (dispositif qui est représenté aussi sur la figure 4), la structure de piégeage comporte 12 grilles réparties en deux lignes parallèles L1 et L2 regroupant chacune six grilles 3. La piste ESR 30 est rectiligne, et parallèle aux deux lignes de grilles L1, L2. En projection sur le plan x,y (plan parallèle à la couche isolante 20), elle passe entre ces deux lignes de grilles, à égale distance de ces deux lignes. L'écart latéral d_{y} entre le bord de la piste 30 et le bord de chaque grille 3, est par exemple inférieur à 100 nm et même inférieur à 30 nm, dans cet exemple.

Comme déjà indiqué, le dispositif est réalisé à partir d'un substrat de type silicium sur isolant SOI. La couche support du substrat, de type HR-Si (épaisse), qui supporte initialement la couche d'oxyde enterrée, peut être entièrement retirée au cours de la fabrication et n'être plus présente dans le dispositif, une fois fabriqué, comme dans le cas des figures 4 à 6. La couche d'oxyde enterrée peut en outre être amincie, soit sur toute sa surface soit plus localement, au niveau de la piste ESR. En variante, la couche support du substrat pourrait être conservée en partie, en étant gravée au niveau de la piste ESR (pour donner accès à la face arrière de la couche d'oxyde enterrée), mais pas sur toute la surface du substrat.

Le dispositif 10 ; 10b ; 11 ; 12 ; 13 ; 14 ; 15 ; 16 ; 17 ; 18 ; 19 comprend un deuxième ensemble de conducteurs électriques d'interconnexion, 27, qui relient électriquement la ou les pistes ESR à des deuxièmes plots ou éléments de contacts 28, distants de cette piste. Ce deuxième ensemble de conducteurs 27 s'étend du côté arrière 24 de la couche isolante 20. Mais il peut éventuellement se prolonger du côté avant 23 (cas de la figure 6), pour permettre un raccord électrique en face avant pour l'ensemble des éléments du dispositif 12.

Ici, la structure de piégeage 1, le premier ensemble de conducteurs 25 d'interconnexion (et plus généralement le BEOL), ainsi que la couche isolante 20 font partie d'une première puce 5 (puce avant). Une deuxième puce 6 ; 7 ; 9 (puce arrière), complétée éventuellement par une troisième puce 8 (figure 6), sert de support au deuxième ensemble de conducteurs 27 (conducteurs qui permettent de déporter la connexion électrique de la piste ou des pistes ESR).

La première puce 5 et la deuxième (et éventuellement troisième) puce 6 ; 7 ; 9 peuvent être assemblées l'une avec l'autre par « hybrid bonding » (cas du dispositif 11 de la figure 5, par exemple) et/ou en ayant recours à des piliers ou micropiliers (« bumps » ou « microbumps) métalliques, avec ou sans microbilles de soudage.

Dans le cas du dispositif 10 des figures 3 et 4 (représenté vu de dessous sur la figure 3, et vu de côté sur la figure 4), la deuxième puce 6 est un interposeur en silicium, traversé par des vias de type TSV (« through silicium via », profonds). Cet interposeur peut comprendre une couche de type RDL (« redistribution layer »), pour re-répartir les connections électriques, d'un point de vue planaire. La connexion électrique de la piste ESR 30 avec les conducteurs électriques 27 de la deuxième puce 6 est obtenue grâce à deux microbilles de soudure 29, et grâce à deux plots de contacts 91, 92 présents initialement sur la première puce 5 et qui se raccordent respectivement à une première extrémité et à une deuxième extrémité de la piste ESR 30 (figure 3), les deux microbilles 29 venant au contact de ces deux plots 91, 92 (de dimension relativement grande, notamment par rapport à la piste 30, pour faciliter le contact avec la deuxième puce 6). L'ensemble comprenant la piste 30 et ces deux plots de contact 91, 92 peut par exemple être gravé dans une même couche de matériau supraconducteur préalablement déposée en face arrière de la première puce 5.

Dans le cas du dispositif 11 de la figure 5, la deuxième puce 9 comprend un substrat 80 en silicium, de préférence en silicium ²⁸SI isotopiquement pur, traversé notamment pas deux vias conducteurs permettant de relier électriquement les deux extrémités de la piste ESR 30 aux éléments de contact distants 28.

Quant au dispositif 12 de la figure 6, il comprend trois puces, 5, 7 et 8 assemblées ensembles. La troisième puce 8, optionnelle, sert à redistribuer les contacts électriques, à l'arrière du dispositif 12. Comme déjà mentionné, dans ce mode de réalisation, le dispositif 12 comprend un renvoi des connexions électriques de la piste ESR 30 en face avant 204 du dispositif 12. Plus précisément, la deuxième puce 7 comprend un substrat en silicium 80, traversé de part en part par deux vias conducteurs 81 mis en contact avec la piste 30 par deux microbilles de soudure 29 pour pouvoir y injecter le courant I_{ESR}, comme pour le dispositif 10 de la figure 4. A l'arrière, ces deux vias 81 sont connectés électriquement à la troisième puce 8 par l'intermédiaire, là aussi de microbilles 82. La troisième puce 8 redistribue ces connexions électriques sur le côté du dispositif 12 (latéralement) pour permettre un retour en face avant. Plus précisément, la troisième puce relie les vias 81 mentionnés plus haut à des vias de retour 84, qui traversent eux aussi le substrat 80 de la deuxième puce 7. Ces vias sont connectés, d'un côté à la puce 8, par des microbilles 82, et de l'autre à la première puce 5 par des microbilles 85 qui les mettent en contact avec des vias 86 qui amènent finalement les deux connexions électriques à la piste 30 au niveau de la face avant 204 du dispositif 12. La troisième puce 8 peut aussi intégrer ou supporter des composants électroniques, actifs ou passif, tels qu'une source de courant électrique ou un transformateur d'impédance. Dans le cas où la troisième puce 8 comprend un tel composant de transformation d'impédance, c'est une puissance électrique P_{RF} qui peut être injectée au niveau de l'élément de contact distant 28, le transformateur d'impédance délivrant, à partir de cette puissance, le courant I_{ESR} (la source de cette puissance P_{RF} étant située hors de l'environnement cryogénique, par exemple). Dans le cas où la troisième puce 8 intègre une source de courant, qui génère le courant I_{ESR}, c'est une tension de commande ou d'alimentation qui peut être appliquée au niveau de l'élément de contact distant 28, pour obtenir une circulation du courant I_{ESR}. Pour ce qui est des signaux de contrôle en tension de la piste ESR, utilisée en tant que grille arrière (pour contrôler le paysage d'énergie où sont piégés les électrons ou trous), comme déjà indiqué, il peut s'agir de signaux continus, alternatifs, impulsionnels, modulés, ou d'une superposition de tels signaux (par exemple une tension continue à laquelle se superposent des impulsions de tensions). On notera qu'il est possible d'utiliser (de partager) un même signal électrique pour les deux fonctionnalités présentées ci-dessus, à savoir la génération du champ magnétique oscillant (pour la résonance ESR), et le contrôle du potentiel électrique de la piste ESR, utilisée comme grille arrière.

Mis à part la présence des vias de retour en face avant 86, la première puce 5 est identique dans le cas du dispositif 12 et dans le cas du dispositif 10. En particulier, la structure de piégeage 1 est la même, avec ses deux lignes de grilles L1 et L2. Et la configuration de la piste ESR, rectiligne, et qui passe en quelque sorte entre ces deux lignes, est aussi la même. Dans le cas du dispositif 11 de la figure 5, la première puce 5 est identique à celle du dispositif 10 de la figure 3, si ce n'est que chaque ligne de grilles 3 comprend trois grilles au lieu de six. La configuration de la piste ESR, rectiligne, et qui, en projection sur le plan x,y, passe entre ces deux lignes, est aussi la même que pour la figure 3.

Le dispositif 10 ; 10b ; 11 ; 12 ; 13 ; 14 ; 15 ; 16 ; 17 ; 18 ; 19 peut aussi comprendre (et cela quel que soit le mode de réalisation) :
- une source de courant, qui délivre le courant alternatif I_{ESR} destiné à alimenter la piste ou les pistes ESR (il peut s'agir d'une source délivrant un courant ou une puissance électrique pilotable), et/ou
- une source de tension électrique, dont une borne de sortie est reliée à la piste ou aux pistes ESR, et qui permet de contrôler le potentiel électrique (V_{DC,AC,} Vᵢₘₚᵤₗₛᵢₒₙₙₑₗ) de cette piste ou de ces pistes (potentiel électrique continu, alternatif à basse fréquence ou à haute fréquence, ou impulsionnel, ou étant une combinaison de tels potentiels électriques ), ce qui donne un degré le liberté supplémentaire pour contrôler le paysage d'énergie dans lequel sont piégés les électrons ou trous.

Ces sources peuvent être intégrées au microcircuit présenté plus haut (microcircuit qui comprend la structure de piégeage 1 et la ou les pistes ESR, et qui est formé par exemple par les puces mentionnées plus haut), ou être réalisées sous la forme de circuits ou d'appareils électriques distincts, reliés électriquement au microcircuit qui intègre la structure de piégeage 1 et la ou les pistes ESR.

### Configuration de la piste ou des pistes ESR

De manière générale, le dispositif 10 ; 10b ; 11 ; 12 ; 13 ; 14 ; 15 ; 16 ; 17 ; 18 ; 19 comprend au moins une ligne de grilles, ou une ligne d'ilots de grilles.

Dans les explications qui suivent, pour la simplicité des explications, on considère que le dispositif comprend une seule grille 3 par qubit, ces grilles étant disposées en lignes (ou éventuellement le long d'une même ligne). Les caractéristiques et l'agencement présentés ci-dessous peuvent toutefois être appliqués de la même manière dans un cas où il y a plusieurs grilles pour chaque qubit (par exemple deux grilles par qubit). Dans ce cas, les différents ilots (groupes) de grilles, associés respectivement aux différents qubits, seront disposés en lignes, de la même manière que les grilles 3 représentées sur les figures. Plus généralement, le dispositif pourrait comprendre plusieurs ilots de grilles, regroupant chacun plusieurs grilles, ces ilots étant agencés de la même manière que les grilles individuelles 3 visibles sur les figures.

Il peut comporter une seule piste ESR, s'étendant, au moins en moyenne, parallèlement à la ligne, ou aux lignes de grilles. Cette piste peut être rectiligne, parallèle à la ligne ou aux lignes de grilles, comme sur la figure 3. Elle peut aussi être non rectiligne, et serpenter de part et d'autre d'un axe moyen xo qui est parallèle à la ligne de grilles (voir les figures 16 et 17 par exemple) ; la piste s'étend alors, en moyenne, le long de cet axe parallèle à la ligne de qubits. La piste ESR s'étend en général sur toute la longueur de la ligne (ou des lignes) de grilles.

Le dispositif peut comporter aussi plusieurs pistes ESR, chacune de ces pistes s'étendant, au moins en moyenne, parallèlement à la ligne, ou parallèlement aux lignes de qubits (voir les pistes 30 - 34 sur les figures 7 et 8 par exemple), ces pistes s'étendant ainsi parallèlement les unes aux autres. En pratique, ces pistes ESR sont alors connectées électriquement en parallèles les unes par rapport aux autres, et le sens du courant est alors le même dans les différentes pistes 30 - 34. Chaque piste 30 - 34 s'étend par exemple depuis un premier plot de contact 91, commun aux différentes pistes, jusqu'à un deuxième plot de contact 92 (figures 7 et 8).

Cette configuration, avec une disposition électrique en parallèle, permet une commutation individuelle de chaque piste 30 - 34, de manière à appliquer sélectivement à telle ou telle ligne de qubits un champ magnétique oscillant, afin de modifier seulement l'orientation des spins de la ligne ainsi sélectionnée. Le dispositif 13 de la figure 7, et le dispositif 14 de la figure 8 comprennent d'ailleurs chacun un commutateur ou sélecteur 90, qui peut être de type actif (i.e.: commandé) ou passif (par exemple à seuil), et qui est interposé, le long des pistes, par exemple entre le premier plot de contact 91 et le début de la zone située à l'aplomb de la matrice de qubit.

Par ailleurs, dans un mode de fonctionnement pour lequel toutes les pistes 30 - 34 seraient parcourues simultanément par le courant I_{ESR}, ou en l'absence du commutateur ou sélecteur 90, on obtient dans cette configuration un champ magnétique oscillant B_{AC} qui a une décroissance assez lente en fonction de la distance (car le sens du courant est le même dans toutes les pistes, contrairement au cas de la figure 9 par exemple). Cette configuration est donc bien adaptée au cas d'une couche isolante 20 relativement épaisse (200 nm par exemple), car la distance entre pistes ESR et qubits est alors assez importante.

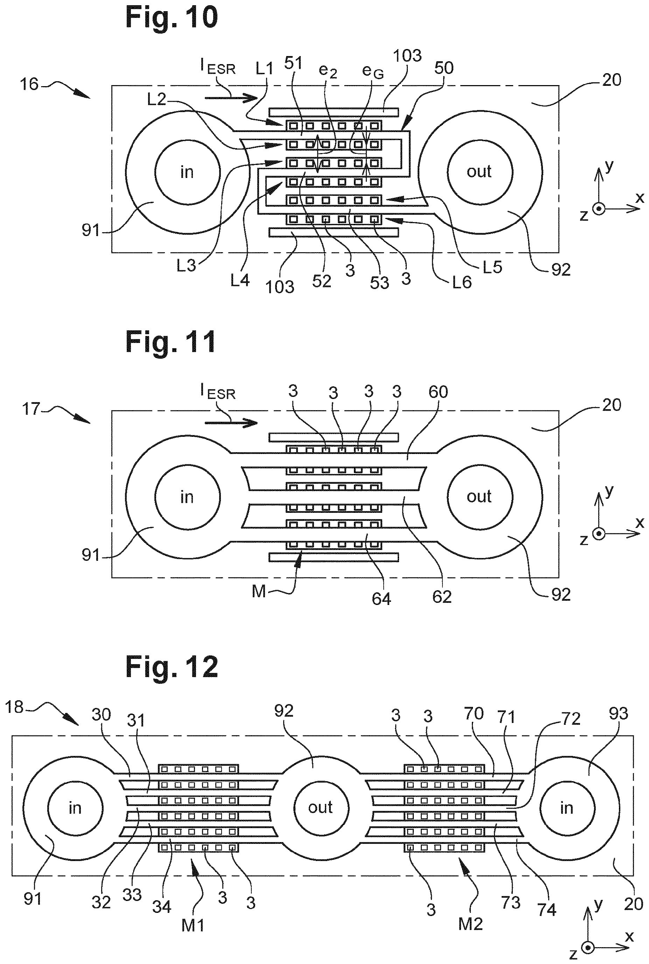

Dans d'autres modes de réalisation, tels que ceux des figures 9 et 10, le dispositif 15 ; 16 comporte une même piste ESR 40 ; 50, mais avec plusieurs portions successives 41 - 45 ; 51 - 53, chaque portion s'étendant, au moins en moyenne, parallèlement à la ligne, ou parallèlement aux lignes de qubits (voir les portions 41 - 43 de la piste 40 sur la figure 9 par exemple), sur toute la longueur de la ligne (ou des lignes) de qubits. Ces différentes portions, parallèles entre elles, sont connectées électriquement en série l'une à la suite de l'autre, la piste 40 ; 50 formant ainsi des méandres, en serpentant d'un côté à l'autre de la matrice de qubits, et ainsi de suite. Le sens du courant électrique s'inverse donc, d'une portion de la piste à la suivante. Par exemple, dans la portion 41 de la piste 40, il circule dans le sens +x tandis que dans la portion suivante 42, il circule dans le sens -x.

Cette configuration permet, dans certains cas comme celui de la figure 9 par exemple, d'obtenir un champ magnétique oscillant dirigé exclusivement ou presque exclusivement selon l'axe z.

Par ailleurs, dans cette configuration, comme le sens du courant s'inverse d'une portion à l'autre de la piste, on obtient un champ magnétique oscillant dont l'amplitude décroît très rapidement avec la distance lorsqu'on s'éloigne de la piste (voir la figure 23 par exemple). Cette configuration est donc bien adaptée au cas d'une couche isolante 20 très mince (par exemple d'épaisseur inférieure à 60 ou même 30 nm), et elle permettra alors de limiter fortement l'amplitude du champ magnétique oscillant ailleurs que sur la structure de piégeage 1.

La configuration de la piste, ou des pistes ESR, pour les modes de réalisation représentés respectivement sur les figures 7 à 11, est présentée maintenant plus en détail, figure par figure. Pour ces cinq modes de réalisation, la structure de piégeage comprend une matrice de qubits M qui comporte six lignes de qubits, c'est-à-dire six lignes de grilles 3, notées L1, L2, L3, L4, L5 et L6, chaque ligne comprenant six qubits. Comme déjà indiqué, ces figures sont présentées à titre illustratif, et le dispositif selon l'invention peut bien entendu comporter un nombre de lignes de grilles différent de six.

Le dispositif 13 de la figure 7 comprend cinq pistes ESR 30, 31, 32, 33, 34 (et plus généralement, dans une telle configuration, le nombre de lignes de qubits est n tandis que le nombre de pistes ESR est n-1). En projection sur un plan parallèle à la couche isolante 20, chaque piste ESR s'étend entre deux lignes de qubits voisines, en étant intercalée entre ces deux lignes, et, en l'occurrence, à égale distance des deux lignes de qubits (au milieu de ces deux lignes). La piste 30 s'étend ainsi entre les lignes L1 et L2, la piste 31 s'étend entre les lignes L2 et L3, la piste 32 s'étend entre les lignes L3 et L4, et ainsi de suite. Les pistes 30 - 34 sont espacées régulièrement les unes des autres, d'un point de vue latéral, avec un pas e1 (pas selon l'axe y) égal au pas e_{G} entre lignes de qubits. Les pistes ESR ont une largeur (extension dans la direction y) inférieure au pas e_{G} en question, par exemple inférieure ou égale à la moitié du pas e_{G}.

Dans cette configuration, au niveau des qubits, le champ magnétique oscillant B_{AC} généré par les pistes ESR, lorsqu'elles sont toutes parcourues par le même courant électrique alternatif, est un champ dont la composante selon l'axe x est nulle, et dont la composante selon l'axe z est très faible (par rapport à la composante selon l'axe y), voire même nulle.

Le dispositif 13 comprend aussi, par exemple de part et d'autre de l'ensemble de pistes 30 - 34, des « dummies » optionnels 103, c'est-à-dire des portions de pistes formées dans le même matériau que les pistes ESR (typiquement un matériau métallique). Ces « dummies », ou « fausses pistes », permettent, lors d'une étape de planarisation et/ou de polissage de l'arrière de couche isolante 20, d'éviter une érosion irrégulière ou excessive de la surface à polir. Ils favorisent aussi l'adhésion entre les puces avant et arrière du dispositif, lorsqu'elles sont assemblées par « hybrid bonding » (dans ce cas, la puce arrière comprendra aussi des « dummies », situées en correspondance de ceux, 103, de la puce avant). En l'occurrence, les « dummies » 103 ont une forme de bande, comparable aux pistes ESR 30 - 34, et sont parallèles à ces pistes.

Le dispositif 14 de la figure 8 est identique en tout point au dispositif 13 de la figure 7, si ce n'est qu'il comprend seulement trois des cinq pistes ESR 30 - 34 mentionnées ci-dessus, à savoir les pistes 30, 32 et 34. Plus généralement, pour ce type de mode de réalisation, le nombre de lignes de qubits est n, avec n pair, et le nombre de pistes ESR est n/2. Les pistes 30, 32, 34 sont espacées régulièrement les unes des autres, d'un point de vue latéral, avec un pas e2 (pas selon l'axe y) égal au double du pas e_{G} entre lignes de qubits. Contrairement au mode de réalisation de la figure 7, le champ magnétique oscillant qui s'exerce sur une ligne de qubits est principalement généré par une seule piste ESR, ici (celle qui est la plus proche de la ligne de qubits en question), au lieu de deux. Et chaque piste ESR est en quelque sorte en charge de la génération du champ magnétique oscillant pour deux lignes de qubits, en l'occurrence pour les deux lignes de qubits situées de part et d'autre de la ligne ESR (par exemple les lignes L1 et L2, pour ce qui est de la piste 30).

Ce mode de réalisation avec, pour l'ensemble de pistes ESR, un pas e2 en quelque sorte relâché par rapport à celui, e_{G}, des lignes de qubits, est plus facile à fabriquer que celui de la figure 7.

Dans cette configuration, au niveau des qubits, le champ magnétique oscillant B_{AC} généré par les pistes ESR, lorsqu'elles sont toutes parcourues par le même courant électrique alternatif, est un champ dont la composante selon l'axe x est nulle. En revanche, contrairement au dispositif 13 de la figure 7, la composante selon l'axe z n'est pas nulle.

Le dispositif 15 de la figure 9 comprend une seule piste ESR 40 qui comporte cinq portions successives 41, 42, 43, 44, 45, chacune parallèle aux lignes de qubits L1 - L6. Comme expliqué plus haut, ces portions se raccordent l'une à la suite de l'autre pour former des méandres qui serpentent d'un côté à l'autre de la matrice de qubits. Dans une telle configuration, le nombre de lignes de qubits est plus généralement égal à n (avec n pair) tandis que le nombre de portions principales de la piste ESR, parallèles aux lignes de qubits, est égal à n-1. La piste 40 s'étend depuis le premier plot de contact 91, à gauche de la matrice de qubits, jusqu'au deuxième plot de contact 92, à droite de cette matrice, en faisant plusieurs aller-retour de gauche à droite.

En projection sur un plan parallèle à la couche isolante 20, chaque portion 41 - 45 de la piste 40 s'étend entre deux lignes de qubits voisines, en étant intercalée entre ces deux lignes, et, en l'occurrence, à égale distance de ces deux lignes de qubits (au milieu de ces deux lignes). La piste 41 par exemple s'étend ainsi entre les lignes L1 et L2, la portion 42 s'étend entre les lignes L2 et L3 et ainsi de suite. Les portions 41 - 45 sont espacées régulièrement les unes des autres, d'un point de vue latéral, avec un pas e1 (pas selon l'axe y) égal au pas e_{G} entre lignes de qubits. Ces portions de piste ESR ont chacune une largeur (extension dans la direction y) inférieure au pas e_{G} en question, par exemple inférieure ou égale à la moitié du pas e_{G}.

Dans cette configuration, au niveau des qubits, le champ magnétique oscillant B_{AC} généré par la piste ESR 40 a des composantes nulles selon l'axe x et selon l'axe y : ce champ est dirigé selon l'axe z. Par ailleurs, pour chaque ligne de qubits, le champ B_{AC} généré au niveau des qubits de la ligne est principalement généré par les deux portions de piste situées de part et d'autre de cette ligne. Par exemple, pour la ligne L3, ce sont principalement les portions 42 et 43 qui contribuent au champ magnétique B_{AC} exercé sur les qubits de cette ligne. Et dans cette configuration, où le sens du courant s'inverse d'une portion à l'autre, les deux contributions, dues respectivement à ces deux portions de ligne, s'ajoutent constructivement, au niveau des qubits (autrement dit, ces deux portions de piste génèrent respectivement deux champs magnétiques ayant, selon l'axe z, des composantes de même signe).

Cette configuration permet de générer un champ magnétique avec une efficacité élevée, c'est-à-dire avec un rapport B_{AC}/i_{ESF} élevé.

Enfin, comme on peut le voir sur la figure 9, le dispositif 15 comprend lui aussi les « dummies » 103 optionnels mentionnés plus haut.

Le dispositif 16 de la figure 10 est semblable à celui de la figure 9 mais avec, entre deux portions successives de la piste ESR 50, un pas e2 égal au double du pas e_{G} entre lignes de qubits (pas selon la direction y). La piste 50 comprend ainsi trois portions principales 51, 52, 53, chacune parallèle aux lignes de qubits L1 - L6, et qui forment ensemble une sorte de serpentin qui serpente entre ces lignes. Plus généralement, pour ce type de mode de réalisation, le nombre de lignes de qubits est égal à n, avec n pair, et le nombre de portions principales de la piste, parallèles aux lignes de qubits, est égal à n/2.

Contrairement au mode de réalisation de la figure 9, le champ magnétique oscillant qui s'exerce sur une ligne de qubits est principalement généré par une seule portion, 51, 52 ou 53 de la piste ESR (portion qui est la plus proche de la ligne de qubits en question), ici, au lieu de deux portions. Et chaque portion est en quelque sorte en charge de la génération du champ magnétique oscillant pour deux lignes de qubits (pour les deux lignes de qubits situées de part et d'autre de la portion considérée).

Ce mode de réalisation avec, pour l'ensemble des pistes ESR, un pas e2 en quelque sorte relâché par rapport à celui e_{G} des lignes de qubits, est plus facile à fabriquer que celui de la figure 9. En revanche, il ne permet pas d'obtenir l'effet de somme constructive mentionnées plus haut, et le rapport B_{AC}/I_{ESR} est moins élevé que pour la configuration de la figure 9. En termes d'orientation, le champ magnétique oscillant B_{AC} généré par la piste 50 au niveau des qubits a une composante selon l'axe x nulle tandis que sa composante selon l'axe z et sa composante selon l'axe y sont généralement non nulles.

Le dispositif 17 de la figure 11 est identique au dispositif 14 de la figure 8, si ce n'est que les trois pistes ESR 60, 62, 64 ont une largeur plus importante que les pistes 30, 32, 34 du dispositif 14. Les pistes 60, 62 et 64 ont par exemple une largeur égale au pas e_{G} qui sépare deux lignes de qubits, ou même supérieure à e_{G}. Cette configuration est plus commode à réaliser que des pistes étroites comme celles de la figure 8, et elle est plus favorable en termes de contrôle du potentiel électrique statique ou impulsionnel à l'arrière des pièges. Cette configuration à pistes larges peut néanmoins influencer les propriétés du champ magnétique généré (en termes de direction, et d'influence éventuelle des effets de bords), et elle est moins favorable en termes d'adressage sélectif de telle ou telle ligne de qubits. Cette structure peut présenter un champ magnétique non homogène en bordure de structure selon l'axe y, avec une composante du champ magnétique en Z non annulée et composante en Y accrue. Afin d'homogénéiser le champ magnétique généré (pour avoir une valeur de champ magnétique comparable pour les différents qubits de la structure), il peut être nécessaire de retirer les portions de canal les plus externes selon l'axe Y ou bien d'ajouter des pistes ESR à l'extérieur de la structure (à la place des « dummies » par exemple), ou encore d'adapter la largeur des pistes selon l'axe Y, en particulier pour les pistes situées près des bords de la structure (pistes 60 et 64). En effet, élargir encore les pistes 60 et 64 permet d'améliorer substantiellement l'homogénéité du champ magnétique au niveau des différents qubits de la matrice M comme confirmé par simulation numérique. Lorsqu'une largeur plus importante est utilisée pour les pistes ESR situées en bordure de structure, on veillera de préférence à conserver, pour l'ensemble des pistes une symétrie par rapport à l'axe médian de la structure (piste 60 aussi large que la piste 64, par exemple).

On notera qu'une telle variante à pistes larges, ou à portions de piste larges (typiquement plus larges que e_{G}/2, ou même plus larges que e_{G} dans le cas des dispositifs 14 et 16) peut être mise en œuvre non seulement pour le dispositif de la figure 8, mais aussi pour ceux des figures 7, 9 et 10.

Dans les modes de réalisation représentés sur les figures 7 et 9, les pistes ESR 30 - 34, ou les portions 41 - 45 de la piste ESR 40, sont décalées latéralement par rapport aux lignes de qubits L1 - L6 (en projection sur le plan xy, elles sont décalées par rapport aux lignes de qubit). En variante, quitte à modifier le nombre de pistes ou de portions de piste, on pourrait prévoir au contraire qu'elles soient situées à l'aplomb (i.e. : au droit) des lignes de qubits, c'est-à-dire qu'elles soient superposées aux lignes de qubits (par exemple centrées sur ces lignes), en projection sur le plan xy. A titre d'exemple, pour le dispositif 13 (figure 7), cela pourrait être obtenu en décalant l'ensemble des pistes 30 - 34 d'une distance e_{G}/2 dans la direction y, et en ajoutant une sixième piste ESR s'étendant, en face arrière, à l'aplomb de la ligne de qubits L6, le long de cette ligne.

Disposer ainsi les pistes ESR, ou les portions de la ligne ESR à l'aplomb des lignes de qubits est favorable en termes de contrôle du potentiel électrique V_{DC,AC,} Vᵢₘₚᵤₗₛᵢₒₙₙₑₗ appliqué en face arrière des pièges. En revanche, cela modifie les propriétés du champ magnétique généré, et, à titre d'exemple, on n'obtient plus l'effet de somme constructive de la configuration représentée sur la figure 9.

La figure 12 montre un dispositif 18 comprenant deux matrices M1 et M2 de 6x6 qubits, chacune identique à la matrice de qubits M du dispositif 13 (figure 7). Le dispositif 18 correspond en quelque sorte à une version dupliquée, étendue, du dispositif 13 de la figure 7.

Les deux matrices de qubits M1 et M2 comprennent chacune six lignes de qubits (avec 6 qubits par ligne), parallèles à l'axe x.

La première matrice M1 est située entre le premier plot de contact 91 et le deuxième plot de contact 92, tandis que la deuxième matrice est située entre le deuxième plot de contact 92 et un troisième plot de contact 93. Les deux matrices M1 et M2 sont alignées avec l'autre (elles sont disposées le long d'une même ligne, parallèle à l'axe x). Un premier ensemble de pistes ESR, comprenant cinq pistes ESR 30 - 34, identiques à celles du dispositif 13 de la figure 7, s'étend depuis le premier plot 91 jusqu'au deuxième plot, et permet de piloter, par résonance de type ESR, les qubits de la première matrice M1. De même, un deuxième ensemble de pistes ESR, comprenant cinq lignes ESR 70 - 74 s'étend depuis le deuxième plot 92 jusqu'au troisième plot 93. Ce deuxième ensemble de lignes ESR, identique au premier ensemble, permet quant à lui de piloter les qubits de la deuxième matrice M2 par résonance de type ESR.

Les premier et troisième plots 91 et 93 sont des plots d'entrée du courant tandis que le deuxième plot 92, commun aux deux ensembles de lignes ESR 30 - 34 et 90 - 94, est un plot de sortie du courant (il est par exemple raccordé à une masse électrique du dispositif.

En variante, les deux ensembles de pistes ESR, qui pilotent respectivement les deux matrices M1 et M2, pourraient être du même type que pour le dispositif 14 de la figure 8, avec une piste ESR pour deux lignes de qubits (au lieu d'avoir une piste ESR pour chaque ligne de qubit).

De même, en variante, on pourrait employer une configuration du même type que pour les dispositifs 15 et 16 avec, pour chaque matrice M1, M2, une seule piste ESR formant des méandres qui serpentent d'un côté à l'autre de la matrice, parallèlement aux lignes de qubits.

D'autre part, au lieu d'avoir un plot de contact commun aux deux ensembles de pistes ESR (le deuxième plot 92), les deux ensembles de pistes ESR, associés respectivement aux deux matrices M1 et M2, pourraient être pourvus chacun de deux plots de contact qui leur soit propres (le dispositif comprenant alors quatre plots de contact).

L'exemple de la figure 12 montre que la structure présentée plus haut, en référence aux figures 7 à 11 (structure avec une matrice de qubits et une ligne ESR en serpentin, ou plusieurs lignes ESR connectées en parallèle), se prête bien à une mise en réseau de plusieurs matrices de qubits, intégrées dans le même dispositif. Ces matrices peuvent être disposées elles-mêmes de manière à former une matrice de matrices (une « méta-matrice »), comme pour le dispositif 19 de la figure 13.

Le dispositif 19 comprend 12 matrices de qubits, chacune comportant six lignes de six qubits (soit 432 qubits). Il comporte également neuf plots de contact 91 - 99, disposés en trois lignes de trois plots. Chaque matrice de qubits est située entre deux des plots 91 - 99 en question. Un ensemble de cinq pistes ESR parallèles est prévu pour chaque matrice, ces pistes s'étendant depuis l'un des plots de contact jusqu'à celui situé de l'autre côté de la matrice considérée.

Les plots 91, 93, 97 et 99, situées aux quatre sommets de cette « méta-matrice », sont des plots d'entrée du courant, de même que celui, 95, situé au centre de la méta-matrice (au centre du réseau). Les autres plots, 92, 94, 96 et 98 (situés aux milieux des quatre côtés de cette méta-matrice) sont des plots de sortie du courant. Chaque plot de contact a une extension latérale proche de, ou même identique à celle de chaque matrice de qubits.

Chaque matrice de qubits peut être équipée d'un commutateur ou sélecteur, comme celui, 90, du dispositif 13 (figure 7).

Cet agencement des matrices de qubits permet une intégration commode, dans le même dispositif, d'un tel réseau de matrices de qubits. En effet, cet agencement laisse un espace substantiel pour chaque plot de contact (ce qui permet de réaliser des plots assez larges permettant de réaliser un bon contact avec une autre puce). Par ailleurs, entre chaque groupe de quatre matrices de qubits, une zone Z1, Z2, Z3, Z4 est laissée libre, ce qui peut être mis à profit pour réaliser d'autres éléments en face arrière, ou comme zone d'entrée de signaux DC pour le contrôle des qubits, ou encore pour un retour en face avant de contacts électriques. Par ailleurs, chaque matrice peut être adressée individuellement, en termes de circulation du courant I_{ESR} (et même, chaque ligne de qubits, lorsque le dispositif est équipé des commutateurs/sélecteurs mentionnés plus haut). Enfin, le dispositif peut être démultiplié librement, en fonction de la taille du réseau de matrices souhaité (un réseau de 4 matrices, aussi bien que de huit fois cinq matrices, ou de k fois I matrices peut être réalisé sur ce même modèle). Dans le dispositif 13 ; 14 ; 15 ; 16 ; 17 ; 18 ; 19, il peut être nécessaire d'homogénéiser le champ magnétique généré au niveau des qubits, en particulier en bordure de structure selon l'axe y. Pour cela, il est possible d'ajuster la largeur des pistes ESR, ou encore d'ajouter des pistes externes de compensation des effets de bords. D'autres solutions pour homogénéiser le champ magnétique généré sont de retirer les portions de canal les plus externes selon l'axe Y.

Dans les modes de réalisation représentés sur les figures 3 et 7 à 13, les pistes ESR sont rectilignes, ou composées de portions rectilignes et parallèles aux lignes de qubits.

Mais, comme mentionné plus haut, ces pistes ESR, ou ces portions de piste affectées à telle ou telle ligne de qubits, peuvent aussi être non rectilignes, et serpenter de part et d'autre d'un axe moyen xo parallèle à la ligne de qubits considérée, comme cela est représenté sur les figures 14 à 21. Sur ces figures, on a représenté, vu de dessous, différentes variantes envisageables pour la géométrie d'une telle piste ESR, ou pour la géométrie d'une portion de piste ESR affectée à une ligne L1 de qubits.

Dans chacun de ces exemples, la piste, 110 ; 120 ; 130 ; 140 ; 150 ; 160 ; 170 ; 180, forme, dans un plan parallèle à la couche isolante (plan (x,y)), au niveau de chaque grille 3 (ou, au niveau de chaque îlot de grilles), en projection sur le plan (x,y), une portion de boucle 111 ; 121 ; 131 ; 141 ; 151 ; 161 ; 171 ; 181. Cette portion de boucle, non rectiligne, entoure en partie un (petit) élément de surface, sur une portion du pourtour de cette surface (sur une portion de sa périphérie). Pour chacun de ces exemples, la piste 110 ; 120 ; 130 ; 140 ; 150 ; 160 ; 170 ; 180 s'étend ainsi dans un plan parallèle à la couche isolante.

En particulier, en projection sur le plan parallèle à la couche isolante, chacune de ces portions de boucles 111 ; 121 ; 131 ; 151 ; 161 ; 171 peut entourer en partie l'une des grilles de la ligne, qui est alors située au centre de la boucle, ou non loin de ce centre, comme dans le cas des figures 14 à 16 et 18 à 20. On notera que c'est bien en projection sur le plan (x,y) que cette portion de boucle entoure (en partie) la grille en question. En effet, comme déjà indiqué, la piste (et donc aussi cette portion de boucle) s'étend dans un plan parallèle à la couche isolante, et d'un côté de la couche isolante opposé à la structure de piégeage. C'est donc la projection géométrique de piste (et non la piste elle-même), qui entoure en partie la grille considérée. Autrement formulé, la grille, qui est décalée verticalement par rapport au plan de la piste, est située à l'aplomb du centre de la portion de boucle, ou non loin de l'aplomb du centre de la portion de boucle.

Différentes formes (présentées en détail plus bas) sont envisageables pour les portions de boucle en question. Ces portions de boucles peuvent par exemple correspondre à une portion d'une boucle circulaire (figures 14 et 18), d'une boucle rectangulaire (figures 16, 17, 19) ou encore d'une boucle triangulaire.

Le fait que la piste forme de telles portions de boucle au voisinage de chaque grille permet de générer un champ magnétique B_{AC} plus intense au niveau du qubit considérés, pour un courant I_{ESR} donné. Par rapport à une piste rectiligne, cette géométrie permet en effet d'augmenter la longueur de piste qui passe au voisinage de la grille (et en outre, pour cette géométrie, les contributions élémentaires, dues à chaque petite partie de la portion de boucle, s'ajoutent vectoriellement les unes aux autres de manière constructive). De plus, cela permet de contrôler l'orientation du champ magnétique généré, par exemple avec une orientation en z (cas des dispositifs 110 et 150). Lorsque le champ magnétique statique B₀ est parallèle au plan des couches (plan xy, ici), et lorsque l'on réalise une mise en réseau de matrices telle que sur la figure 13 (dispositif 19), il est particulièrement utile que le champ magnétique oscillant généré par chaque piste soit dirigé selon l'axe z. En effet, comme certaines pistes ESR seront alors parallèles à l'axe x tandis que d'autres seront parallèles à l'axe y, pour obtenir un champ magnétique oscillant qui soit à chaque fois orthogonal au champ statique B₀ (pour chaque piste ESR), orthogonalité qui est nécessaire pour la résonance ESR, il est souhaitable que le champ magnétique oscillant créé soit dirigé selon l'axe z, pour chaque piste.

On notera que, au lieu d'être centrées sur les grilles, les portions de boucles 141 ; 181 peuvent être décalées latéralement, de manière à ce que la piste 140 ; 180 se superpose avec la grille considérée (passe dessous, au droit de celle-ci). Comme mentionné plus haut, un tel agencement est favorable du point de vue du contrôle du potentiel électrique DC en face arrière des pièges. Et en termes de champ magnétique généré, il reste intéressant car il minimise la distance entre la ligne et le qubit considéré.

Pour les pistes 110 ; 120 ; 130 ; 140 et 150 des figures 12 à 18, les portions de boucles, 111 ; 121 ; 131 ; 141 et 151 respectivement, sont répétées régulièrement le long de la piste avec un pas e_{1,x} (pas selon l'axe x) qui est égal au pas e_{G,X} entre grilles 3 (pas selon l'axe x). Par ailleurs, deux portions de boucles successives 111 ; 121 ; 131 ; 141 ; 151 sont raccordées l'une à l'autre par une portion de piste 112 ; 122 ; 132 ; 142 ; 152 qui, ici est rectiligne, parallèle à la ligne de grilles. Ainsi, par exemple, les deux portions de boucles 121 trapézoïdales visibles sur la figure 15 sont reliées l'une à l'autre par la portion rectiligne 122. Ces portions rectilignes permettent, tout au moins dans le cas des figures 14 à 17, d'installer un commutateur entre deux qubits (quitte à décaler la portion rectiligne 112 ; 122 ; 132 ; 142 dans la direction y plus loin que ce qui est représenté sur les figures). Un tel commutateur permet par exemple d'appliquer des potentiels électriques différents, en face arrière des qubits, en amont ou en aval du commutateur.

La forme des portions de boucles est précisée maintenant pour les pistes 110 ; 120 ; 130 ; 140 et 150. Pour la piste 110 (figure 14), les portions de boucles 111 ont chacune la forme d'une portion de cercle ou d'ellipse (elles forment un arc outrepassé). Pour la piste 120 (figure 15), les portions de boucles 121 sont formées chacune par trois côtés d'un trapèze (à savoir la base et les deux côtés inclinés). Pour la piste 130, et pour la piste 140 (figures 16 et 17), les portions de boucles 131 sont formées chacune par trois côtés d'un carré ou d'un rectangle (il s'agit donc d'une portion d'une boucle rectangulaire). La piste 130, ou 140, forme ainsi une ligne en créneaux. Pour la piste 150 (figure 18), les portions de boucles 151 forment chacune un arc de cercle.

En l'occurrence, la piste 150 comprend au moins deux portions, 153 et 154, raccordées l'une à la suite de l'autre (comme pour la figure 10), chacune parallèle, en moyenne, à la ligne de grilles 3. Le sens du courant s'inverse ainsi, de la portion 153 à la portion 154. Comme chacune de ces portions présente, au niveau des grilles, des portions de boucles en forme arc de cercle, on obtient finalement, autour de chaque grille, une boucle circulaire presque complète (c'est-à-dire presque un cercle complet - voir la figure 18), et un champ magnétique proche de ce qui serait obtenue avec une boucle circulaire parcourue par le courant I_{ESR}.

Pour les pistes 160 ; 170 et 180 des figures 19 à 21, les portions de boucles, 161 ; 171 et 181 respectivement, sont répétées régulièrement le long de la piste avec un pas e_{2,x} qui est égal au double du pas e_{G,X} entre grilles (pas selon l'axe x).

Dans le cas de la figure 19, par exemple, la piste 160 a une forme ondulée, avec une demi-boucle circulaire 161 (demi-cercle) ouverte d'un côté, puis, immédiatement après, une demi-boucle circulaire 161 ouverte de l'autre côté, et ainsi de suite. Au centre de chaque demi-boucle circulaire 161 se trouve une grille (en projection sur le plan x,y), aussi bien pour les demi-boucles ouvertes du côté +y que pour celles ouvertes du côté -y.

La piste 160 serpente ainsi d'un côté puis de l'autre des grilles, le long de la ligne L1 (alors que dans le cas des figures 14 à 17, la piste serpente, mais en restant toujours du même côté des grilles, par exemple du côté +y). Il en est de même pour la piste 170 de la figure 20, et pour la piste 180 de la figure 21. Dans le cas de la figure 21, la piste 180 est identique à la piste 160 de la figure 19, mais les grilles sont décalées latéralement les uns par rapports aux autres (elles sont réparties le long d'une sorte de ligne brisée, en triangles), de manière à être situés au droit de la piste 180, à l'aplomb de celle-ci. Et dans le cas de la figure 20, la piste 170 a une forme de créneau, chaque portion de boucle 171 ayant la forme d'une demi-spire rectangulaire, ouverte successivement du côté +y, puis du côté -y et ainsi de suite.

Les géométries de piste (ou de portion de piste) présentées ci-dessus, en référence aux figures 14 à 17 et 19 à 21, peuvent être employées notamment dans le cas des dispositifs 13, 15, 18 ou 19 présentés plus haut (pour lesquels l'écart latéral e2 entre pistes ou portions de piste est égal à l'espace latéral entre lignes de grilles), à la place de pistes ou de portions de pistes rectilignes. Il peut être alors nécessaire d'agencer les pistes ESR deux par deux en vis-à-vis afin de garantir un champ magnétique constructif. Pour les dispositifs 14, 16 ou 17, les figures 17 et 21 peuvent être adaptées si les lignes de grille sont décalées selon x d'un demi-écart entre grille. Pour la figure 18, on utilise contrairement aux cas précédents deux portions de lignes ESR par ligne de grille. Pour l'ensemble des cas, du fait de la longueur accrue des lignes ESR, il est préférable d'utiliser un matériau supraconducteur afin d'éviter d'avoir une résistance de ligne trop élevée. De même afin de réduire la longueur totale, une configuration en ilots de grilles est préférable, en particulier pour les cas des figures 14 et 18.

Par ailleurs, ces géométries de piste peuvent aussi être employées dans des dispositif comprenant des ilots de grilles, regroupant chacun quelques grilles, par exemple deux ou quatre grilles, ces ilots étant disposés en ligne les uns à la suite des autres. Dans ce cas, la géométrie de la piste sera la même que ce qui a été présenté ci-dessus, si ce n'est que chaque portion de boucle entourera en partie un îlot de grilles, au lieu d'entourer une grille unique. Dans un tel, chaque îlot de grilles peut servir à stocker, contrôler et manipuler un seul qubit, ou plusieurs qubits.

Les figures 22 et 23 montrent des résultats de simulation numérique réalisées pour deux exemples de dispositifs tels que ceux présentés plus haut. Ces figures montrent le dispositif en coupe axiale, selon un plan parallèle au plan y,z (l'axe x, est quant à lui perpendiculaire au plan de la figure). L'amplitude de l'excitation magnétique H_{AC} (amplitude des variations de la norme de H_{AC} au cours du temps), générée par le courant électrique I_{ESR} qui traverse la ou les pistes, est représentée en niveaux de gris. Une échelle précisant les valeurs correspondantes de H_{AC}, exprimées en ampère par mètre, est également représentée.

Dans le cas de la figure 22, le dispositif comprend quatre lignes de qubits L1 à L4, et trois pistes ESR 30, 31 et 32 parcourues pas un courant électrique qui a le même sens dans ces trois pistes. Le pas e_{G} entre lignes de qubit est de 100 nm. Il est égal au pas e_{1,Y} entre pistes ESR. Les pistes ESR ont une largeur et une épaisseur de 30 nm. La distance dz entre les pistes et les faces arrière des grilles (espacement « vertical » entre pistes est qubits) est de 100 nm environ. Le courant électrique total (somme pour les trois pistes 30, 31, 32) a une amplitude crête à crête d'environ 4 mA.

Dans le cas de la figure 23, le dispositif comprend cinq lignes de qubits L1 à L5, et une piste avec quatre portions 41, 42, 43, 44 parcourues pas un courant électrique dont le sens change d'une portion à l'autre (c.f. dispositif de la figure 9). Le pas e_{G} entre lignes de qubit est de 100 nm. Il est égal au pas e_{1,Y} entre portions successives de la piste ESR. Les portions de la piste ESR ont une largeur et une épaisseur de 30 nm. Pour cette simulation, qui sert principalement d'illustration, la distance dz est nulle. Le courant électrique qui circule dans la piste a une amplitude crête à crête inférieure à 4 mA.

La comparaison des figures 22 et 23 illustrent bien que la configuration avec une piste en serpentin (figure 23) et un courant électrique à contresens d'une portion à l'autre génère un champ magnétique qui, selon la direction z, est localisé très près de la piste (entre les portions rectilignes en question 41 -44), et qui décroît rapidement lorsque l'on s'éloigne de la piste. Au contraire, le champ magnétique créé par le système de pistes de la figure 22 a une décroissance plus lente lorsque l'on s'écarte de l'ensemble des pistes selon l'axe z.

Différentes variantes peuvent être apportées aux modes de réalisation qui ont été décrits ci-dessus, en plus de celles déjà mentionnées.

Ainsi, la structure de piégeage pourrait être réalisée de manière différente, avec par exemple un nombre de grilles plus important pour chaque qubit (c'est-à-dire pour chaque piège ; on pourrait par exemple prévoir deux grilles ou plus pour chaque piège, pour disposer de plus de degrés de liberté pour contrôler les caractéristiques des puits de potentiel créé).

Par ailleurs, au lieu d'être réalisé à base de silicium, et à partir d'un substrat de type SOI, le dispositif pourrait être réalisé à partir d'un substrat de type GeOI, en germanium sur isolant.

On notera d'autre part que les différentes variantes et modes de réalisation présentés ci-dessus peuvent être combinés ensemble selon toutes les combinaisons techniquement envisageables.

## Revendications

1. Dispositif (15 ; 16) électronique pour le stockage, le contrôle et la manipulation de qubits sur semi-conducteur, à base de spins d'électron ou de trou, le dispositif comprenant :
- une couche isolante (20) électriquement avec, du côté avant (23), une face avant (21), et du côté arrière (24), une face arrière (22),
- sur la face avant (21) de la couche isolante (20), une structure de piégeage (1) pour électrons ou trous qui comporte :
∘ une portion de canal (2), formée au moins en partie par une portion de couche en matériau semi-conducteur s'étendant dans un plan parallèle à ladite couche isolante (20), et
∘ une pluralité de grilles (3) distinctes les unes des autres, réparties en un ou plusieurs niveaux sur la portion de canal (2), d'un côté de la portion de canal (2) opposé à ladite couche isolante (20), les grilles (3) de la structure de piégeage (1) étant réparties le long de lignes (L1 - L6) parallèles entre elles et
- du côté arrière (24) de la couche isolante (20), une piste électrique ( 40 ; 50) qui s'étend dans un plan parallèle à la couche isolante, destinée à générer un champ magnétique oscillant (B_{AC}) s'exerçant sur ledit au moins un électron ou trou piégé dans la structure de piégeage (1), la piste (40 ; 50) comportant plusieurs portions (41 - 45 ; 51 - 53), chacune parallèle auxdites lignes (L1 - L6), et qui sont connectées électriquement en série les unes à la suite des autres pour former des méandres.

2. Dispositif (15 ; 16) selon la revendication 1, dans lequel la couche isolante (20) a une épaisseur comprise entre 5 nm et 200 nm, voire comprise entre 10nm et 150 nm.

3. Dispositif (15 ; 16) selon l'une des revendications précédentes, dans lequel ladite piste (40 ; 50) et lesdites grilles (3) sont séparées par une distance (dz) inférieure ou égale à 200 nm, selon une direction (z) perpendiculaire à la couche isolante (20).

4. Dispositif selon l'une des revendications précédentes, dans lequel ladite piste (30) est séparée de ladite face arrière (22) par une couche intermédiaire (102).

5. Dispositif (15 ; 16) selon l'une des revendications précédentes, dans lequel la couche isolante (20) est une couche en oxyde de semi-conducteur constituant une partie au moins de la couche d'oxyde enterré d'un substrat de type semi-conducteur sur isolant, tel qu'un substrat de type Silicium sur isolant « SOI » ou de type Germanium sur isolant « GeOI ».

6. Dispositif (15 ; 16) selon l'une des revendications précédentes, comprenant en outre :
- un premier ensemble de conducteurs (25) électriques d'interconnexion, qui relient électriquement les grilles (3) à des premiers plots ou éléments de contacts (26) distants de la structure de piégeage (1), ce premier ensemble de conducteurs (25) s'étendant du coté avant (23) de la couche isolante (20), et
- un deuxième ensemble de conducteurs (27) électriques d'interconnexion, qui relient électriquement ladite piste (40 ; 50 ) à des deuxièmes plots ou éléments de contacts (28) distants de ladite piste, ce deuxième ensemble de conducteurs (27) s'étendant du côté arrière (24) de la couche isolante (20) ,
- le dispositif (15 ; 16 ) ne comprenant pas de connecteur électrique qui soit relié électriquement aux grilles (3) et qui soit situé du côté arrière (24) de la couche isolante, ou, ne comprenant pas de connecteur électrique qui soit relié électriquement à ladite piste (40 ; 50) et qui soit situé du côté avant (23) de la couche isolante.

7. Dispositif selon l'une des revendications précédentes, dans lequel, en projection sur un plan parallèle à la couche isolante (20), la piste se superpose au moins en partie avec chacune des grilles (3).

8. Dispositif (15) selon l'une des revendications précédentes, dans lequel lesdites portions de piste (41 - 45), sont espacées latéralement l'une de l'autre de manière périodique, avec un espacement (e1) qui est le même que l'espacement (e_{G}) qui sépare, latéralement, deux lignes de grilles (L1, L2, L3, L4, L5, L6) adjacentes.

9. Dispositif (16) selon l'une des revendications précédentes, dans lequel lesdites portions de piste (51, 52, 53) sont espacées latéralement l'une de l'autre de manière périodique, avec un espacement (e2) qui est le double de l'espacement (e_{G}) qui sépare, latéralement, deux lignes de grilles (L1, L2, L3, L4, L5, L6) adjacentes.

10. Dispositif selon l'une des revendications 1 à 9, dans lequel ladite piste (110 ; 120 ; 130 ; 140 ; 150 ; 160 ; 170 ; 180) forme plusieurs portions de boucle (111 ; 121 ; 131 ; 141 ; 151 ; 161 ; 171 ; 181), chaque portion de boucle étant située au niveau de l'une desdites grilles (3), ou au niveau d'un îlot de grilles regroupant une partie desdites grilles (3), en projection sur un plan parallèle à la couche isolante (20).

11. Procédé de pilotage d'un dispositif (15 ; 16) électronique selon l'une des revendications précédentes, dans lequel un courant électrique alternatif (I_{ESR}) est injecté dans la ladite piste électrique (30) pour générer ledit champ magnétique oscillant (B_{AC}), et dans lequel la piste électrique (30) est employée en outre en tant que grille arrière, un potentiel électrique (V_{DC,AC,} Vᵢₘₚᵤₗₛᵢₒₙₙₑₗ) étant appliqué à ladite piste électrique (30) pour contrôler un paysage de potentiel électrique au sein de la portion de canal (2) où est piégé ledit au moins un électron ou trou, ledit potentiel électrique (V_{DC,AC,} Vᵢₘₚᵤₗₛᵢₒₙₙₑₗ) étant un potentiel électrique statique, ou basse fréquence, ou radiofréquence, ou impulsionnel, ou étant une combinaison de tels potentiels électriques.

12. Procédé de fabrication d'un dispositif (15 ; 16) électronique pour le stockage, le contrôle et la manipulation de qubits sur semi-conducteur, à base de spins d'électron ou de trou, le dispositif comprenant une couche isolante (20) électriquement avec, du côté avant (23), une face avant (21), et du côté arrière (24), une face arrière (22), le procédé comprenant les étapes suivantes :
- sur la face avant (21) de la couche isolante (20), réalisation d'une structure de piégeage (1) pour électrons ou trous qui comporte :
∘ une portion de canal (2), formée au moins en partie par une portion de couche en matériau semi-conducteur s'étendant dans un plan parallèle à ladite couche isolante (20), et
∘ une pluralité de grilles (3) distinctes les unes des autres, réparties en un ou plusieurs niveaux sur la portion de canal (2), d'un côté de la portion de canal (2) opposé à ladite couche isolante (20), les grilles (3) de la structure de piégeage (1) étant réparties le long de lignes (L1 - L6) parallèles entre elles, et
- du côté arrière (24) de la couche isolante (20), réalisation d'une piste électrique (40 ; 50) qui s'étend dans un plan parallèle à la couche isolante, destinée à générer un champ magnétique oscillant (B_{AC}) s'exerçant sur ledit au moins un électron ou trou piégé dans la structure de piégeage (1), la piste (40 ; 50) comportant plusieurs portions (41 - 45 ; 51 - 53), chacune parallèle auxdites lignes (L1 - L6), et qui sont connectées électriquement en série les unes à la suite des autres pour former des méandres.
